(19) Europäisches Patentamt
European Patent Office
Office européen des brevets

(11) **EP 4 346 040 A1**

(12) **EUROPEAN PATENT APPLICATION**

(43) Date of publication:
**03.04.2024 Bulletin 2024/14**

(21) Application number: **22207618.4**

(22) Date of filing: **15.11.2022**

(51) International Patent Classification (IPC):
*H02H 3/00* (2006.01)   *G01R 31/08* (2020.01)
*G01R 31/52* (2020.01)   *H02H 3/34* (2006.01)
*H02H 7/26* (2006.01)

(52) Cooperative Patent Classification (CPC):
**H02H 7/26; G01R 31/085; H02H 3/006;**
**H02H 3/343;** H02H 3/042; H02H 3/325; H02H 3/353

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **27.09.2022 IN 202241055326**

(71) Applicant: **Hitachi Energy Ltd**
**8050 Zürich (CH)**

(72) Inventors:
• NAIDU, OD
  **560087 Karnataka (IN)**
• KHAN, Yasir Ullah
  **462023 Madhya Pradesh (IN)**
• GEORGE, Neethu
  **560049 Karnataka (IN)**
• PRADHAN, Vedanta
  **751024 Bhubaneswar (IN)**

(74) Representative: **Vossius & Partner**
**Patentanwälte Rechtsanwälte mbB**
**Siebertstraße 3**
**81675 München (DE)**

(54) **FAULT TYPE IDENTIFICATION METHOD IN ELECTRICAL POWER SYSTEM**

(57) The present disclosure relates to a method for controlling a protection system for an electrical power system comprising a transmission line, the method comprising: determining a plurality of phase angle deviations based on network models of the electrical power system during respective faults of at least three faults; determining at least three phase angle ranges based on the plurality of phase angle deviations, wherein a sum of the at least three phase angle ranges is an angle of complete rotation; and controlling the protection system for the electrical power system based on the at least three phase angle ranges.

FIG. 7

EP 4 346 040 A1

## EP 4 346 040 A1

### Description

### Technical Field

The present disclosure relates to a method, device, computer-readable medium, and system for an electrical power system comprising a transmission line

### Background

Present environmental concern requires large-scale converter-interfaced renewable power plants, CIRPPs, to be integrated to transmission networks and accordingly different control schemes are being applied through the converters connected to CIRPPs. To satisfy the fault ride through requirement as imposed by different grid codes, CIRPPs are to be connected even during fault. Presence of such converter interfaced renewable resources in the network modulates the fault voltage and current signals, and these are significantly different from traditional synchronous generators. These different fault characteristics have negative impact on performance of available phase selection or fault classification logics, which were designed for traditional grids dominated by synchronous generators.

A precise phase selection may refer to the ability of protective intelligent electronic devices, IEDs, to identify faulted phase(s), which is a pre-requisite for a single pole auto-reclosing. Phase selection or fault classification may be performed by identifying which of the 6 loop (3 phase-to-ground and 3 phase-to-phase loops) impedances enter a pre-defined characteristic.

A first approach for the phase selection includes the relay comparing the relative angles between pure-fault sequence currents available at the local end and identifies the fault type in the network. Such approach remains unaffected by fault resistance and load imbalance and classifies the fault types fast and accurately. In a second approach, adverse effect of phase angle variation in the positive sequence current is avoided in some relays by utilizing the angle difference between negative and zero-sequence currents only. In this technique, fault resistances are estimated for discrimination between single-line-to-ground and double-line-to-ground faults. In another approach, the phase angle difference of superimposed sequence voltages are utilized in some of the relays along with current angle feature for fault type classification in weak-infeed situation.

All the phasor-based techniques described above assume homogeneity (angles of local and remote currents close to each other) in the system, which is true for traditional power networks connecting conventional generations. However, these methods have limitations when applied to lines connected with converter interfaced renewable resources due to modulated voltage and current signals during fault and assumption of homogeneity not being true anymore. Yet another approach classifies fault adaptively for transmission networks connected with CIRPPs, wherein the non-homogeneity factor is calculated assuming that the grid is strongly connected. This technique will not work if grid is weakly connected.

Therefore, there is a need for an accurate phase selection method for networks, in particular connected with CIRPPs.

### Summary

The present disclosure relates to a method for a protection system for an electrical power system comprising a transmission line, the method comprising: determining a plurality of phase angle deviations based on network models of the electrical power system during respective faults of at least three faults; determining at least three phase angle ranges based on the plurality of phase angle deviations, wherein a sum of the at least three phase angle ranges is an angle of complete rotation .

According to an embodiment, the transmission line is terminated by a first terminal coupled to a first generator and by a second terminal coupled to a second generator, the method further comprising: obtaining a plurality of voltage measurements of the first terminal; determining a measured phase-angle deviation based on the plurality of voltage measurements; and determining a fault by identifying in which of the at least three phase angle ranges the measured phase-angle deviation is located, in particular by comparing the measured phase-angle deviation to at least one of the at least three phase angle ranges.

According to an embodiment, the method further comprises: determining a plurality of further phase angle deviations based on the network models of the electrical power system during the respective faults of at least three further faults; and determining at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

2

According to an embodiment, the method further comprises: obtaining a plurality of voltage measurements of the first terminal; determining a further measured phase-angle deviation based on the plurality of voltage measurements; and determining the fault by identifying in which of the at least three further phase angle ranges the measured phase-angle deviation is located, in particular by comparing the measured phase-angle deviation to at least one of the at least three further phase angle ranges.

According to an embodiment, the method further comprises: obtaining a plurality of current measurements of the first terminal; determining a zero-sequence current based on the plurality of current measurements of the first terminal; and determining the fault based further on the zero-sequence current, in particular by comparing a zero-sequence current to a pre-set value.

According to an embodiment, the measured phase-angle deviation is a phase angle difference between a first phase angle and a second phase angle, wherein the first phase angle is a phase angle of a negative sequence voltage measured during a fault, and wherein the second phase angle is a phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a negative sequence voltage measured during a fault, and wherein the second phase angle is a phase angle of a zero sequence voltage measured during the fault or a phase angle difference between a phase angle of a positive sequence voltage measured before the fault and a phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, the method comprising: obtaining a plurality of voltage measurements of the first terminal measured before a fault and during the fault; and determining a n-phase fault based on voltage differences between respective phases of the plurality of voltage measurements measured before the fault and the plurality of voltage measurements measured during the fault, wherein n is a natural number, larger than 1, corresponding to the number of the plurality of phases.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation the plurality of phase angle deviations.

According to an embodiment, each of the at least three further phase angle ranges includes the respective phase angle deviation the plurality of further phase angle deviations.

The present disclosure relates to a method for controlling a protection system for an electrical power system comprising a transmission line, the method comprising: receiving the at least three phase angle ranges determined according to any one of above-described embodiments; and controlling the protection system for the electrical power system based on the at least three phase angle ranges.

The present disclosure relates to a method for controlling a protection system for an electrical power system comprising a transmission line, the method comprising: determining a plurality of phase angle deviations based on network models of the electrical power system during respective faults of at least three faults; determining at least three phase angle ranges based on the plurality of phase angle deviations, wherein a sum of the at least three phase angle ranges is an angle of complete rotation; and controlling the protection system for the electrical power system based on the at least three phase angle ranges.

According to an embodiment, the transmission line is terminated by a first terminal coupled to a first generator and by a second terminal coupled to a second generator, the method further comprising: obtaining a plurality of voltage measurements of the first terminal; determining a measured phase-angle deviation based on the plurality of voltage measurements; determining a fault by identifying in which of the at least three phase angle ranges the measured phase-angle deviation is located, in particular by comparing the measured phase-angle deviation to at least one of the at least three phase angle ranges; and controlling the protection system for the electrical power system based on the determined fault.

According to an embodiment, the method further comprises: determining a plurality of further phase angle deviations based on the network models of the electrical power system during the respective faults of at least three further faults; and determining at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

According to an embodiment, the method further comprises: obtaining a plurality of voltage measurements of the first terminal; determining a further measured phase-angle deviation based on the plurality of voltage measurements; determining the fault by identifying in which of the at least three further phase angle ranges the measured phase-angle deviation is located, in particular by comparing the measured phase-angle deviation to at least one of the at least three further phase angle ranges; and controlling the protection system for the electrical power system based on the determined fault.

According to an embodiment, the method further comprises: obtaining a plurality of current measurements of the first terminal; determining a zero-sequence current based on the plurality of current measurements of the first terminal; determining the fault based further on the zero-sequence current, in particular by comparing a zero-sequence current to a preset value; and controlling the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, the method comprising: obtaining a plurality of voltage measurements of the first terminal measured before a fault and during the fault; determining a n-phase fault based on voltage differences between respective phases of the plurality of voltage measurements measured before the fault and the plurality of voltage measurements measured during the fault, wherein n is a natural number, larger than 1, corresponding to the number of the plurality of phases; and controlling the protection system is further based on the determined n-phase fault.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a method for a protection system for an electrical power system comprising a transmission line being terminated by a first terminal, the method comprising: determining a plurality of phase angle deviations based on network models of the electrical power system during respective faults of at least three faults; determining at least three phase angle ranges based on the plurality of phase angle deviations, wherein a sum of the at least three phase angle ranges is an angle of complete rotation; obtaining a plurality of voltage and current measurements of the first terminal; determining a measured phase-angle deviation based on the plurality of voltage measurements and a zero-sequence current based on the plurality of current measurements of the first terminal; and determining a fault based on the at least three phase angle ranges, the measured phase-angle deviation, and the zero-sequence current.

According to an embodiment, the method further comprises: determining a plurality of further phase angle deviations based on the network models of the electrical power system during the respective faults of at least a further faults set; determining at least three further phase angle ranges based on the further plurality of phase angle deviations, wherein a sum of the at least three further phase angle ranges is an angle of complete rotation; determining a further measured phase-angle deviation based on the plurality of voltage measurements; and determining the fault by identifying in which of the at least three further phase angle ranges the measured phase-angle deviation is located, in particular by comparing the measured phase-angle deviation to at least one of the at least three further phase angle ranges.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the method further comprises: obtaining a plurality of voltage measurements of the first terminal measured before a fault and during the fault; and determining a n-phase fault based on voltage differences between respective phases of the plurality of voltage measurements measured before the fault and the plurality of voltage measurements measured during the fault, wherein n is a natural number, larger than 1, corresponding to the number of the plurality of phases.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a method for controlling a protection system for an electrical power system comprising a transmission line being terminated by a first terminal, the method comprising: receiving the at least three phase angle ranges, the measured phase angle deviation, zero-sequence current, and/or the fault determined according to any one of above-described embodiments; and controlling the protection system for the electrical power system based on the determined fault.

The present disclosure also relates to a method for controlling a protection system for an electrical power system comprising a transmission line being terminated by a first terminal, the method comprising: determining a plurality of phase angle deviations based on network models of the electrical power system during respective faults of at least three faults; determining at least three phase angle ranges based on the plurality of phase angle deviations, wherein a sum of the at least three phase angle ranges is an angle of complete rotation; obtaining a plurality of voltage and current measurements of the first terminal; determining a measured phase-angle deviation based on the plurality of voltage measurements and a zero-sequence current based on the plurality of current measurements of the first terminal; determining a fault based on the at least three phase angle ranges, the measured phase-angle deviation, and the zero-sequence current; and controlling the protection system for the electrical power system based on the determined fault.

According to an embodiment, the method further comprises: determining a plurality of further phase angle deviations based on the network models of the electrical power system during the respective faults of at least a further faults set; determining at least three further phase angle ranges based on the further plurality of phase angle deviations, wherein a sum of the at least three further phase angle ranges is an angle of complete rotation; determining a further measured phase-angle deviation based on the plurality of voltage measurements; determining the fault by identifying in which of the at least three further phase angle ranges the measured phase-angle deviation is located, in particular by comparing the measured phase-angle deviation to at least one of the at least three further phase angle ranges; and controlling the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the method further comprises: obtaining a plurality of voltage measurements of the first terminal measured before a fault and during the fault; determining a n-phase fault based on voltage differences between respective phases of the plurality of voltage measurements measured before the fault and the plurality of voltage measurements measured during the fault, wherein n is a natural number, larger than 1, corresponding to the number of the plurality of phases; and controlling the protection system is further based on the determined n-phase fault.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a device for a protection system for an electrical power system comprising a transmission line, the device comprising a processor being configured to: determine a plurality of phase angle deviations based on network models of the electrical power system during respective faults of at least three faults; determine at least three phase angle ranges based on the plurality of phase angle deviations, wherein a sum of the at least three phase angle ranges is an angle of complete rotation.

According to an embodiment, the transmission line is terminated by a first terminal coupled to a first generator and by a second terminal coupled to a second generator, the processor is further configured to: obtain a plurality of voltage measurements of the first terminal; determine a measured phase-angle deviation based on the plurality of voltage measurements; and determine a fault by identifying in which of the at least three phase angle ranges the measured phase-angle deviation is located, in particular by comparing the measured phase-angle deviation to at least one of the at least three phase angle ranges.

According to an embodiment, the processor is further configured to: determine a plurality of further phase angle deviations based on the network models of the electrical power system during the respective faults of at least three further faults; and determine at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

According to an embodiment, the processor is further configured to: obtain a plurality of voltage measurements of the first terminal; determine a further measured phase-angle deviation based on the plurality of voltage measurements; and determine the fault by identifying in which of the at least three further phase angle ranges the measured phase-angle deviation is located, in particular by comparing the measured phase-angle deviation to at least one of the at least three further phase angle ranges.

According to an embodiment, the processor is further configured to: obtain a plurality of current measurements of the first terminal; determine a zero-sequence current based on the plurality of current measurements of the first terminal; determine the fault based further on the zero-sequence current, in particular by comparing a zero-sequence current to a preset value; and control the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, the processor is further configured to: obtain a plurality of voltage measurements of the first terminal measured before a fault and during the fault; and determine a n-phase fault based on voltage differences between respective phases of the plurality of voltage measurements measured before the fault and the plurality of voltage measurements measured during the fault, wherein n is a natural number, larger than 1, corresponding to the number of the plurality of phases.

According to an embodiment, the processor is further configured to: obtain a plurality of current measurements of the first terminal; determine a generator type of the first generator based on the plurality of current measurements and/or the plurality of voltage measurements; and determine the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a device for controlling a protection system for an electrical power system comprising a transmission line, the device comprising a processor being configured to: receive the at least three phase angle ranges determined according to anyone of above-described embodiments; and control the protection system for the electrical power system based on the at least three phase angle ranges and the at least three second phase angle ranges.

The present disclosure also relates to a device for controlling a protection system for an electrical power system comprising a transmission line, the device comprising a processor being configured to: determine a plurality of phase angle deviations based on network models of the electrical power system during respective faults of at least three faults; determine at least three phase angle ranges based on the plurality of phase angle deviations, wherein a sum of the at least three phase angle ranges is an angle of complete rotation; and control the protection system for the electrical power system based on the at least three phase angle ranges.

According to an embodiment, the transmission line is terminated by a first terminal coupled to a first generator and by a second terminal coupled to a second generator, the processor is further configured to: obtain a plurality of voltage measurements of the first terminal; determine a measured phase-angle deviation based on the plurality of voltage measurements; determine a fault by identifying in which of the at least three phase angle ranges the measured phase-angle deviation is located, in particular by comparing the measured phase-angle deviation to at least one of the at least three phase angle ranges; and control the protection system for the electrical power system based on the determined fault.

According to an embodiment, the processor is further configured to: determine a plurality of further phase angle deviations based on the network models of the electrical power system during the respective faults of at least three further faults; and determine at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

According to an embodiment, the processor is further configured to: obtain a plurality of voltage measurements of the first terminal; determine a further measured phase-angle deviation based on the plurality of voltage measurements; determine the fault by identifying in which of the at least three further phase angle ranges the measured phase-angle deviation is located, in particular by comparing the measured phase-angle deviation to at least one of the at least three further phase angle ranges; and controlling the protection system for the electrical power system based on the determined fault.

According to an embodiment, the processor is further configured to: obtain a plurality of current measurements of the first terminal; determine a zero-sequence current based on the plurality of current measurements of the first terminal; determine the fault based further on the zero-sequence current, in particular by comparing a zero-sequence current to a preset value; and control the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, the processor is further configured to: obtain a plurality of voltage measurements of the first terminal measured before a fault and during the fault; determine a n-phase fault based on voltage differences between respective phases of the plurality of voltage measurements measured before the fault and the plurality of voltage measurements measured during the fault, wherein n is a natural number, larger than 1, corresponding to the number of the plurality of phases; and controlling the protection system is further based on the determined n-phase fault.

According to an embodiment, the processor is further configured to: obtain a plurality of current measurements of the first terminal; determine a generator type of the first generator based on the plurality of current measurements and/or the plurality of voltage measurements; and determine the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a device for a protection system for an electrical power system comprising a transmission line, the device comprising a processor being configured to: determine a plurality of phase angle deviations based on network models of the electrical power system during respective faults of at least three faults; determine at least three phase angle ranges based on the plurality of phase angle deviations, wherein a sum of the at least three phase angle ranges is an angle of complete rotation; obtain a plurality of voltage and current measurements of the first terminal; and determine a measured phase-angle deviation based on the plurality of voltage measurements and a zero-sequence current based on the plurality of current measurements of the first terminal; determine a fault based on the at least three phase angle ranges, the measured phase-angle deviation, and the zero-sequence current.

According to an embodiment, the processor is further configured to: determine a plurality of further phase angle deviations based on the network models of the electrical power system during the respective faults of at least three further faults; determine at least three further phase angle ranges based on the further plurality of phase angle deviations, wherein a sum of the at least three further phase angle ranges is an angle of complete rotation; and determine a further measured phase-angle deviation based on the plurality of voltage measurements; determine the fault by identifying in which of the at least three further phase angle ranges the measured phase-angle deviation is located, in particular by comparing the measured phase-angle deviation to at least one of the at least three further phase angle ranges.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the processor is further configured to: obtain a plurality of voltage measurements of the first terminal measured before a fault and during the fault; and determine a n-phase fault based on voltage differences between respective phases of the plurality of voltage measurements measured before the fault and the plurality of voltage measurements measured during the fault, wherein n is a natural number, larger than 1, corresponding to the number of the plurality of phases.

According to an embodiment, the processor is further configured to: obtain a plurality of current measurements of the first terminal; determine a generator type of the first generator based on the plurality of current measurements and/or the plurality of voltage measurements; and determine the measured phase-angle deviation based on the plurality of voltage measurements when the first generator is determined to be a first generator type; or determine the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a device for controlling a protection system for an electrical power system comprising a transmission line, the device comprising a processor being configured to: receive the at least three phase angle ranges, the measured phase angle deviation, zero-sequence current, and/or the fault determined according to any one of above-described embodiments; and control the protection system for the electrical power system based on the determined fault.

The present disclosure also relates to a device for controlling a protection system for an electrical power system comprising a transmission line, the device comprising a processor being configured to: determine a plurality of phase angle deviations based on network models of the electrical power system during respective faults of at least three faults; determine at least three phase angle ranges based on the plurality of phase angle deviations, wherein a sum of the at least three phase angle ranges is an angle of complete rotation; obtain a plurality of voltage and current measurements of the first terminal; determine a measured phase-angle deviation based on the plurality of voltage measurements and a zero-sequence current based on the plurality of current measurements of the first terminal; determine a fault based on the at least three phase angle ranges, the measured phase-angle deviation, and the zero-sequence current; and control the protection system for the electrical power system based on the determined fault.

According to an embodiment, the processor is further configured to: determine a plurality of further phase angle deviations based on the network models of the electrical power system during the respective faults of at least three further faults; determine at least three further phase angle ranges based on the further plurality of phase angle deviations, wherein a sum of the at least three further phase angle ranges is an angle of complete rotation; determine a further measured phase-angle deviation based on the plurality of voltage measurements; determine the fault by identifying in which of the at least three further phase angle ranges the measured phase-angle deviation is located, in particular by comparing the measured phase-angle deviation to at least one of the at least three further phase angle ranges; and control the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the processor is further configured to: obtain a plurality of voltage measurements of the first terminal measured before a fault and during the fault; determine a n-phase fault based on voltage differences between respective phases of the plurality of voltage measurements measured before the fault and the plurality of voltage measurements measured during the fault, wherein n is a natural number, larger than 1, corresponding to the number of the plurality of phases; and control the protection system is further based on the determined n-phase fault.

According to an embodiment, the processor is further configured to: obtain a plurality of current measurements of the first terminal; determine a generator type of the first generator based on the plurality of current measurements and/or the plurality of voltage measurements; and determine the measured phase-angle deviation based on the plurality of voltage measurements when the first generator is determined to be a first generator type; or determine the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

The present disclosure also relates to a computer-readable medium, for controlling a protection system for an electrical power system, carrying instructions to perform the method of any one of the above-described embodiments.

The present disclosure further relates to an electrical power system comprising a transmission line and a device of any of the above-mentioned embodiments.

Various exemplary embodiments of the present disclosure are directed to providing features that will become readily apparent by reference to the following description when taken in conjunction with the accompanying drawings. In accordance with various embodiments, exemplary systems, methods, and devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

In the following, exemplary embodiments of the present disclosure will be described. It is noted that some aspects of any one of the described embodiments may also be found in some other embodiments unless otherwise stated or obvious. However, for increased intelligibility, each aspect will only be described in detail when first mentioned and any repeated description of the same aspect will be omitted.

The above and other aspects and their implementations are described in greater detail in the drawings, the descriptions, and the claims.

**Brief Description of the Drawings**

Fig. 1 illustrates a flowchart of a method according to an embodiment of the present disclosure.

Fig. 2 illustrates a model of a power system according to an embodiment of the present disclosure.

Fig. 3 illustrates a model of a power system during a fault according to an embodiment of the present disclosure.

Fig. 4 illustrates a model of a power system during a fault according to an embodiment of the present disclosure.

Fig. 5 illustrates ranges of phase angles for a fault in a power system according to an embodiment of the present disclosure.

Fig. 6 illustrates ranges of phase angles for a fault in a power system according to an embodiment of the present disclosure.

Fig. 7 illustrates ranges of phase angles for various faults in a power system according to an embodiment of the present disclosure.

Fig. 8 illustrates a flowchart of a method according to an embodiment of the present disclosure.

Fig. 9 illustrates a flowchart of a method according to an embodiment of the present disclosure.

Fig. 10 illustrates a power system under test according to an embodiment of the present disclosure.

Fig. 11 illustrates voltage and current measurements obtained during a fault of a power system according to an embodiment of the present disclosure.

Fig. 12 illustrates graphs of phase angles, ranges of phase angles, and currents computed according to an embodiment of the present disclosure.

Fig. 13 illustrates computed phase angles and ranges of phase angles computed according to an embodiment of the present disclosure.

Fig. 14 illustrates voltage and current measurements obtained during a fault of a power system according to an embodiment of the present disclosure.

Fig. 15 illustrates graphs of phase angles, ranges of phase angles, and currents computed according to an embodiment of the present disclosure.

Fig. 16 illustrates computed phase angles and ranges of phase angles computed according to an embodiment of the present disclosure.

Fig. 17 illustrates voltage and current measurements obtained during a fault of a power system according to an embodiment of the present disclosure.

Fig. 18 illustrates graphs of phase angles and ranges of phase angles computed according to an embodiment of the present disclosure.

Fig. 19 illustrates a graph of currents computed according to an embodiment of the present disclosure.

Fig. 20 illustrates computed phase angles and ranges of phase angles computed according to an embodiment of the present disclosure.

Fig. 21 illustrates a power system under test according to an embodiment of the present disclosure.

Fig. 22 illustrates a performance summary of the method according to an embodiment of the present disclosure.

Fig. 23 illustrates a power system under test according to an embodiment of the present disclosure.

Fig. 24 illustrates a performance summary of the method according to an embodiment of the present disclosure.

Fig. 25 illustrates a power system under test according to an embodiment of the present disclosure.

Fig. 26 illustrates a performance summary of the method according to an embodiment of the present disclosure.

Fig. 27 illustrates a power system under test according to an embodiment of the present disclosure.

Fig. 28 illustrates a performance summary of the method according to an embodiment of the present disclosure.

Fig. 29 illustrates a performance summary of the method according to an embodiment of the present disclosure.

Fig. 30 illustrates a device, a computer-readable medium, and a system according to an embodiment of the present disclosure.

## Detailed Description of the Disclosure

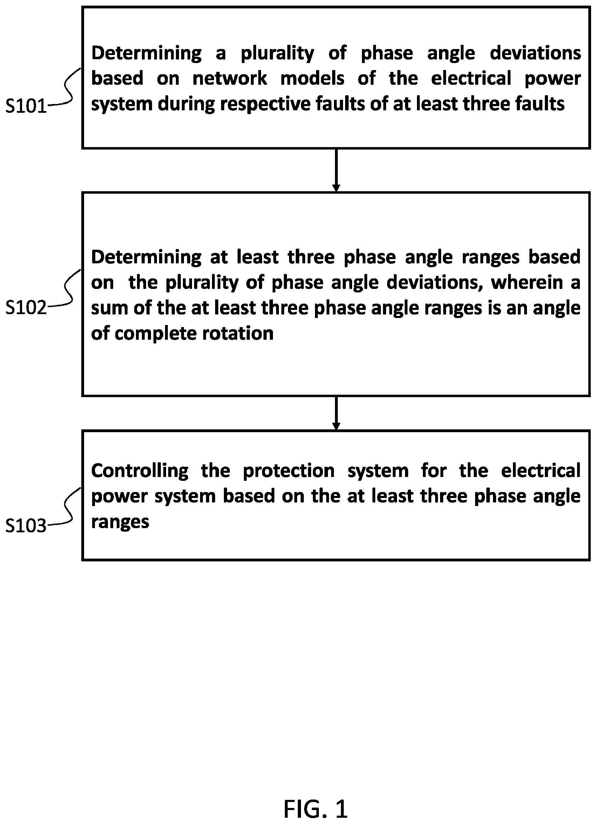

Fig. 1 illustrates a flowchart of a method according to an embodiment of the present disclosure. At S101, a plurality of phase angle deviations is determined based on network models of the electrical power system during respective faults of at least three faults. At S102, at least three phase angle ranges is determined based on the plurality of phase angle deviations, wherein a sum of the at least three phase angle ranges is an angle of complete rotation. At S103, the protection system for the electrical power system is controlled based on the at least three phase angle ranges.

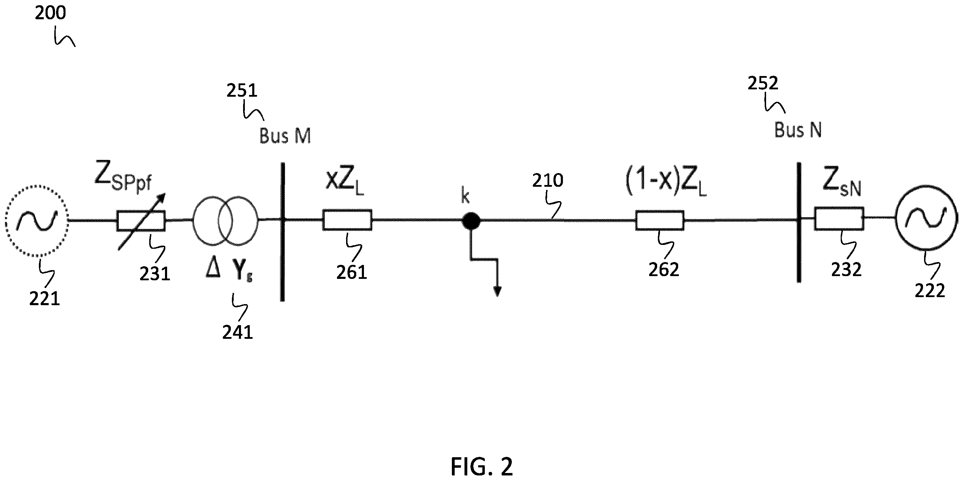

Fig. 2 illustrates a model of a power system according to an embodiment of the present disclosure. The network 200 comprises a first power source 221 connected to a second power source 222 via a transmission line 210. In this embodiment, the first power source 221 is an asynchronous power source, in particular converter interfaced renewable power plant, CIRPP, and the second power source 222 is a power grid. According to an embodiment, the first power source and/or the second power source may be a synchronous source. Equivalent impedances of the CIRPP 221 and the grid 222 are $Z_{SP_{Pf}}$ 231 and $Z_{SN}$ 232, respectively. The transmission line 210 is terminated by a first terminal 251, Bus M in this embodiment, and a second terminal 252, Bus N in this embodiment. According to an embodiment, the transmission line is terminated by a further terminal such as a third terminal, a fourth terminal, and so on. The CIRPP 221 is coupled to Bus M 251 via a delta-wye transformer 241. The line impedance of the transmission line 210, in particular the protected portion between Bus M 251 and Bus N 252, is modelled with an impedance $Z_L$, in particular per unit distance. When a fault occurs at point K, the impedance between bus M 251 and the point K is modelled as $xZ_L$ and the impedance between bus N 252 and the point K is modelled as $(1 - x)Z_L$. $Z_{SP_{Pf}}$ may vary with each instant and may be calculated as follows:

$$Z_{SP_{Pf}} = \frac{V_M^{Pre} - V_M^{f}}{I_M^{f} - I_M^{Pre}} \qquad (1)$$

wherein, $V_M^{Pre}$ and $V_M^{f}$ are fault voltages measured at the local terminal, i.e. Bus M 251, before a fault instance and during the fault, respectively, and $I_M^{Pre}$ and $I_M^{f}$ are fault currents measured at the local terminal, Bus M 251, before the fault instance and during the fault, respectively.

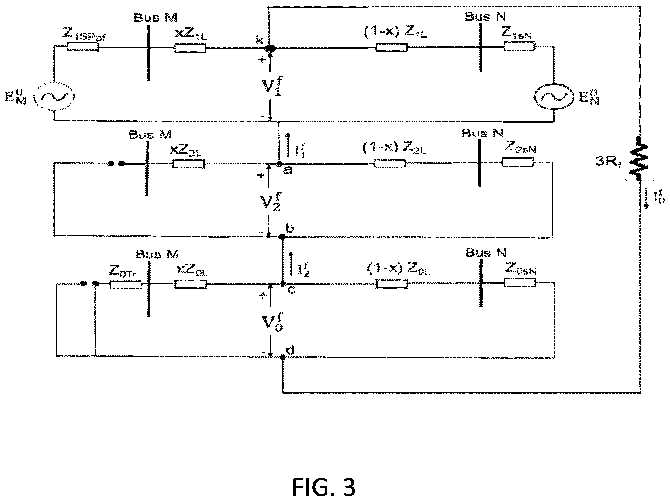

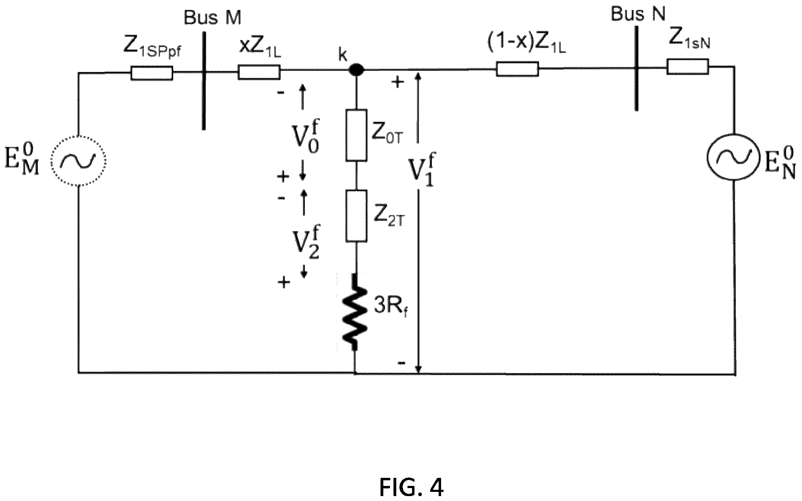

In the following, a phase-to-ground fault, in particular phase-A-to-ground, AG, fault is considered. Fig. 3 illustrates a model, in particular a sequence diagram, of a power system of Fig.2 during a fault, in particular the AG fault, according to an embodiment of the present disclosure. Fig. 4 illustrates a simplified sequence diagram of Fig.3. $Z_{1SP_{pf}}$ in Fig. 3 and Fig. 4 may be the equivalent impedance $Z_{SP_{pf}}$ 231 of the network 200. The rest of the parameters of Fig. 3 and Fig. 4 may be defined as follows:

$V_1^{Pre}$ = Positive sequence pre-fault voltage

$V_1^{f}$ = Positive sequence voltage during fault

$V_2$ = Negative sequence voltage during fault

$V_0$ = Zero-sequence voltage during fault

$Z_{1T}$ = Total positive sequence impedance at fault point(k)
$Z_{2T}$ = Total Negative sequence impedance across point a and b
$Z_{0T}$ = Total Zero-sequence impedance across point c and d
$Z_{SP_{pf}}$ = Equivalent impedance of CIRPP during the fault
$Z_{SN}$ = Equivalent impedance of remote source

Applying the Kirchhoff's current law, KCL, at the fault point k yields:

$$\frac{V_1^f - E_M^0}{Z_{SP_{Pf}} + xZ_{1L}} + \frac{V_1^f - E_N^0}{Z_{SN} + (1-x)Z_{1L}} + \frac{V_1^f}{Z_{2T} + Z_{0T} + 3R_f} = 0 \qquad (2)$$

which can be rearranged as follows:

$$\frac{V_1^f}{Z_{SP_{Pf}} + xZ_{1L}} + \frac{V_1^f}{Z_{SN} + (1-x)Z_{1L}} + \frac{V_1^f}{Z_{2T} + Z_{0T} + 3R_f} = \frac{E_M^0}{Z_{SP_{Pf}} + xZ_{1L}} + \frac{E_N^0}{Z_{SN} + (1-x)Z_{1L}} \qquad (3)$$

• Further rearranging eq.(2) yields:

$$\frac{V_1^f(Z_{SN} + (1-x)Z_{1L} + Z_{SP_{Pf}} + xZ_{1L})}{(Z_{SN} + (1-x)Z_{1L})(Z_{SP_{Pf}} + xZ_{1L})} + \frac{V_1^f}{Z_{2T} + Z_{0T} + 3R_f}$$
$$= \frac{E_M^0(Z_{SN} + (1-x)Z_{1L}) + E_N^0(Z_{SP_{Pf}} + xZ_{1L})}{Z_{SP_{Pf}} + xZ_{1L}\,(Z_{SN} + (1-x)Z_{1L})} \qquad (4)$$

which is equivalent to the following:

$$\frac{V_1^f\left(\left(Z_{SN} + Z_{SP_{Pf}} + Z_{1L}\right)\left(Z_{2T} + Z_{0T} + 3R_f\right) + (Z_{SN} + (1-x)Z_{1L})\left(Z_{SP_{Pf}} + xZ_{1L}\right)\right)}{(Z_{SN} + (1-x)Z_{1L})(Z_{SP_{Pf}} + xZ_{1L})\,(Z_{2T} + Z_{0T} + 3R_f)}$$
$$= \frac{E_M^0(Z_{SN} + (1-x)Z_{1L}) + E_N^0(Z_{SP_{Pf}} + xZ_{1L})}{Z_{SP_{Pf}} + xZ_{1L}\,(Z_{SN} + (1-x)Z_{1L})} \qquad (5)$$

• As $Z_{SN} \ll Z_{SPPf}$ and $Z_{SN} \ll Z_{SPPf} + Z_{1L}$, eq.(5) may be simplified as follows:

$$\frac{V_1^f\left(\left(Z_{SP_{Pf}} + Z_{1L}\right)\left(Z_{2T} + Z_{0T} + 3R_f\right) + (Z_{SN} + (1-x)Z_{1L})\left(Z_{SP_{Pf}} + xZ_{1L}\right)\right)}{(Z_{2T} + Z_{0T} + 3R_f)}$$
$$= E_M^0(Z_{SN} + (1-x)Z_{1L}) + E_N^0(Z_{SP_{Pf}} + xZ_{1L}) \qquad (6)$$

• Rearranging eq.(6) for $V_1^f$ yields:

$$V_1^f = \frac{(E_M^0(Z_{SN} + (1-x)Z_{1L}) + E_N^0(Z_{SP_{Pf}} + xZ_{1L}))(Z_{2T} + Z_{0T} + 3R_f)}{\left(Z_{SP_{Pf}} + Z_{1L}\right)\left(Z_{2T} + Z_{0T} + 3R_f\right) + (Z_{SN} + (1-x)Z_{1L})\left(Z_{SP_{Pf}} + xZ_{1L}\right)} \qquad (7)$$

- As $\dfrac{Z_{1L}}{Z_{SP_{Pf}}} \ll 1$ , eq.(7) may be simplified as follows:

$$V_1^f = \frac{Z_{SP_{Pf}}\left(E_M^0\left(\dfrac{Z_{SN}+(1-x)Z_{1L}}{Z_{SP_{Pf}}}\right)+E_N^0\left(1+\dfrac{xZ_{1L}}{Z_{SP_{Pf}}}\right)\right)(Z_{2T}+Z_{0T}+3R_f)}{Z_{SP_{Pf}}\left(1+\dfrac{Z_{1L}}{Z_{SP_{Pf}}}\right)(Z_{2T}+Z_{0T}+3R_f)+(Z_{SN}+(1-x)Z_{1L})\left(1+\dfrac{xZ_{1L}}{Z_{SP_{Pf}}}\right)} \qquad (8)$$

- As the ratio $\dfrac{Z_{1L}}{Z_{SP_{Pf}}}$ is much smaller than 1, in particular in the order of $1 \times 10^{-2}$ or below, during the fault compared to transmission line impedance and remote end impedance, eq.(8) may be further simplified as follows:

$$V_1^f = \frac{E_N^0(Z_{2T}+Z_{0T}+3R_f)}{(Z_{2T}+Z_{0T}+3R_f)+(Z_{SN}+(1-x)Z_{1L})} \qquad (9)$$

Homogeneity in a conventional transmission network allows the grid equivalent impedance, $Z_{SN}$, to be expressed in terms of protected line impedance, $Z_L$, with real valued multiplier $K_{1,2,0}$, for each sequence component, i.e. a positive, a negative, and a zero-sequence components, respectively. That is, $Z_{SN}$ may be expressed as follows:

$$Z_{SN} = K_{1,2,0}Z_{1L} \qquad (10)$$

Substituting eq.(10) into eq.(9) yields:

$$V_1^f = \frac{E_N^0(Z_{2T}+Z_{0T}+3R_f)}{(Z_{2T}+Z_{0T}+3R_f)+((1-x+K_1)Z_{1L})} \qquad (11)$$

Which may be simplified with $Z_{1T} = (1 - x + K_1)Z_{1L}$, as follows:

$$V_1^f = \frac{E_N^0(Z_{2T}+Z_{0T}+3R_f)}{(Z_{2T}+Z_{0T}+3R_f)+((1-x+K_1)Z_{1L})} = \frac{E_N^0(Z_{2T}+Z_{0T}+3R_f)}{(Z_{1T}+Z_{2T}+Z_{0T}+3R_f)} \qquad (12)$$

- In reference to Fig.4, applying a voltage division of the positive sequence voltage, the negative sequence voltage may be obtained as follows:

$$V_2 = \frac{V_1^f Z_{2T}}{Z_{2T}+Z_{0T}+3R_f} \qquad (13)$$

- Substituting eq.(12) into eq.(13), the following is obtained:

$$V_2 = \frac{E_N^0 Z_{2T}}{Z_{1T}+Z_{2T}+Z_{0T}+3R_f} \qquad (14)$$

- Similarly, the zero-sequence voltage can be expressed as follows:

$$V_0 = \frac{E_N^0 Z_{2T}}{Z_{1T} + Z_{2T} + Z_{0T} + 3R_f} \qquad (15)$$

- For an AG fault a superimposed voltage can be written as follows:

$$\Delta V_1 = V_1^f - V_1^{Pre} = V_1^f - E_N^0 \qquad (16)$$

- Substituting eq.(12) into eq.(16) yields:

$$\Delta V_1 = \frac{E_N^0 Z_{1T}}{Z_{1T} + Z_{2T} + Z_{0T} + 3R_f} \qquad (17)$$

The positive sequence index, $\delta_V^+$, may be calculated as a difference in angle of the negative sequence fault voltage with respect to the superimposed positive sequence fault voltage, as follows:

$$\delta_V^+ = \angle V_2 - \angle \Delta V_1 = \arg\left(\frac{V_2}{\Delta V_1}\right) = \arg\left(\frac{Z_{2T}}{Z_{1T}}\right) = 0° \qquad (18)$$

The zero-sequence index, $\delta_V^0$, may be calculated as a difference in angle of the negative sequence fault voltage with respect to the zero-sequence fault voltage, as follows:

$$\delta_V^0 = \angle V_2 - \angle V_0 = \arg\left(\frac{V_2}{V_0}\right) = \arg\left(\frac{Z_{2T}}{Z_{0T}}\right) = 0° \qquad (19)$$

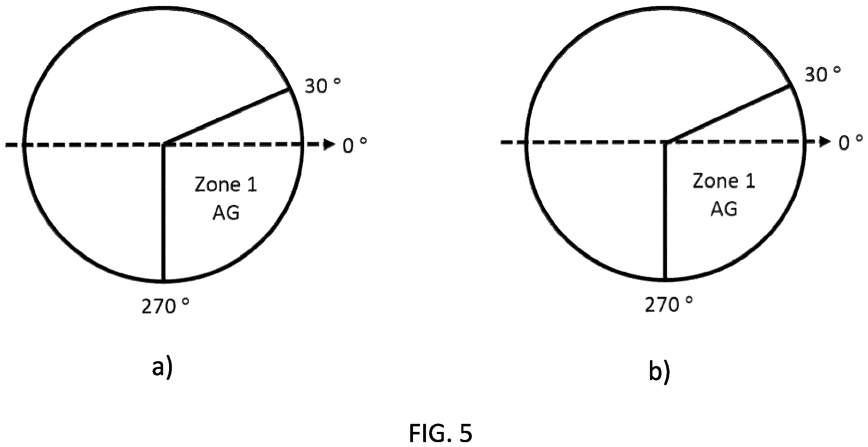

A phase angle range, also referred herein as a zone, for AG fault classification may be determined based on eq.(18) and eq.(19), as shown in Fig. 5.
Fig. 5 illustrates ranges of phase angles indicative of a fault, in particular the AG fault, in a power system, in particular of Fig.2, according to an embodiment of the present disclosure. In particular, Fig. 5a) and Fig.5 b) illustrate phase angle ranges of $\delta_V^+$ and $\delta_V^0$ for the AG fault, respectively. The zone is a range of phase angles having an upper limit and a lower limit, wherein the computed $\delta_V^+$ and $\delta_V^0$ are equal to the upper limit or the lower limit, or are located between the respective upper limit and lower limit. According to an embodiment, the difference between the upper limit and the lower limit, i.e. the width of the range, is determined based on a pre-set value or an adaptive value, in particular based on the computed $\delta_V^+$ and $\delta_V^0$. According to an embodiment, the upper limit and/or the lower limit is determined based on a pre-set value or an adaptive value, in particular based on the computed $\delta_V^+$ and $\delta_V^0$.
Similar to the AG fault, the superimposed voltage for phase-B-to-phase-C-to-ground, BCG, fault can be written as follows:

$$\Delta V_1 = - \frac{E_N^0 Z_{1T}}{Z_{1T} + \left(Z_{2T} || (Z_{0T} + 3R_f)\right)} \qquad (20)$$

- The negative sequence for the BCG fault can be written as follows:

$$V_2 = - \frac{E_N^0 \left( Z_{2T} || (Z_{0T} + 3R_f) \right)}{Z_{1T} + \left( Z_{2T} || (Z_{0T} + 3R_f) \right)} \qquad (21)$$

and the zero-sequence voltage for the BCG fault can be written as follows:

$$V_0 = - \frac{E_N^0 \left( Z_{2T} || (Z_{0T} + 3R_f) \right)}{Z_{1T} + \left( Z_{2T} || (Z_{0T} + 3R_f) \right)} \qquad (22)$$

- Accordingly, the positive sequence index, $\delta_V^+$, can be written as:

$$\delta_V^+ = \angle V_2 - \angle \Delta V_1 = \arg \left( - \frac{Z_{2T} || (Z_{0T} + 3R_f)}{Z_{1T}} \right) = 180° \qquad (23)$$

and the zero-sequence index, $\delta_V^0$, can be written as:

$$\delta_V^0 = \angle V_2 - \angle V_0 = 0° \qquad (24)$$

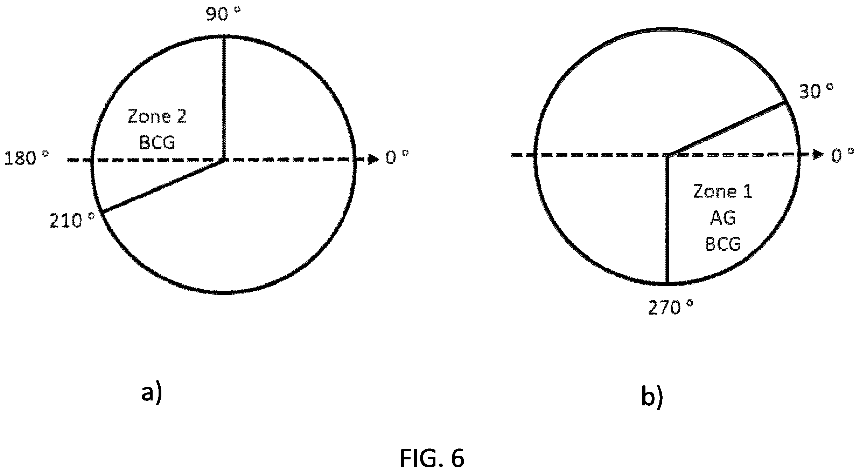

The BCG fault classification may be determined based on eq.(23) and eq.(24), as shown in Fig. 6.

Fig. 6 illustrates ranges of phase angles indicative of a fault, in particular the BCG fault, in a power system, in particular of Fig.2, according to an embodiment of the present disclosure. In particular, Fig. 6a) and Fig. 6b) illustrate phase angle ranges of $\delta_V^+$ and $\delta_V^0$ for the BCG fault, respectively. Note that the zones for AG fault in Fig. 6 is borrowed from previously introduced zones for AG faults illustrated in Fig. 5. The zone is a range of phase angles having an upper limit and a lower limit, wherein the computed $\delta_V^+$ and $\delta_V^0$ are equal to the upper limit or the lower limit, or are located between the respective upper limit and lower limit. According to an embodiment, the difference between the upper limit and the lower limit, i.e. the width of the range, is determined based on a pre-set value or an adaptive value, in particular based on the computed $\delta_V^+$ and $\delta_V^0$. According to an embodiment, the upper limit and/orthe lower limit is determined based on a pre-set value or an adaptive value, in particular based on the computed $\delta_V^+$ and $\delta_V^0$.

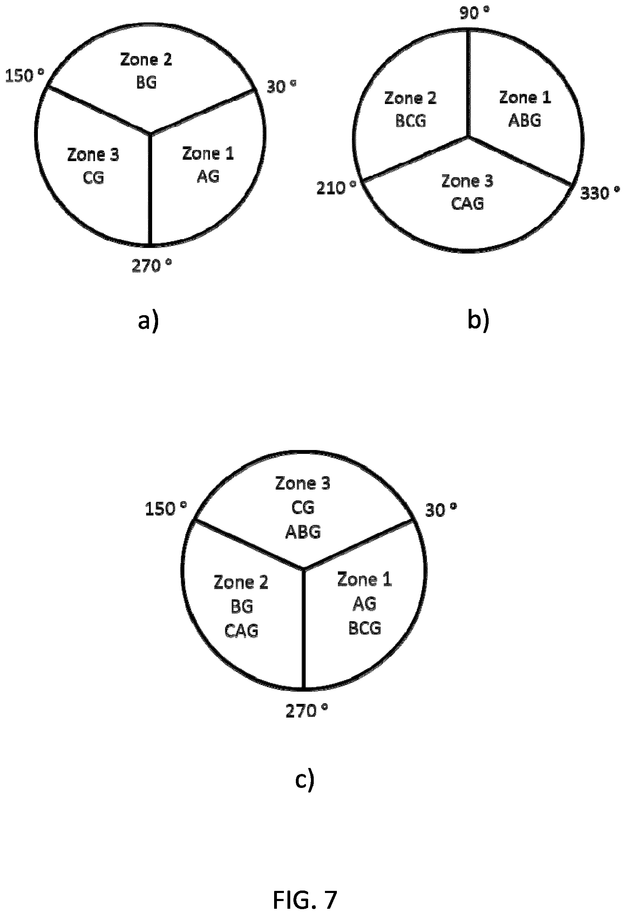

The above-mentioned analysis for computing $\delta_V^+$ and $\delta_V^0$ may be performed for any further fault, including a BG fault, CG fault, ABG fault, CAG fault, AB fault, BC fault, and CA fault, wherein each of the alphabets A, B, and C denote phase-A, phase-B, and phase-C carried on the transmission line, respectively and the alphabet G denotes for the ground. That is, for instance, a CAG fault refers to a phase C-to-phase A-to-ground fault. The resulting zones of $\delta_V^+$ and $\delta_V^0$ for a phase-to-ground fault and a phase-to-phase-to-ground fault are illustrated in Fig. 7. According to an embodiment, the resulting zones of $\delta_V^+$ and $\delta_V^0$ for a phase-to-phase fault is determined.

Fig. 7 illustrates ranges of phase angles for a various fault in a power system according to an embodiment of the present disclosure. In particular, Fig. 6a) and Fig. 6b) illustrate phase angle ranges of $\delta_V^+$ for phase-to-phase faults and phase-to-phase-to-ground faults, respectively and Fig. 7c) illustrates phase angle ranges of $\delta_V^0$ for phase-to-phase faults and phase-to-phase-to-ground faults.

The following illustrates a method for identifying a fault, in particular the fault type, based on the ranges of phase angles shown in Fig. 7.

At first, voltage and current measurements of a local terminal is obtained. According to an embodiment the local terminal is coupled to an asynchronous power source. According to an embodiment the local terminal is Bus M 251 of Fig. 2. At second, the positive sequence, the negative sequence, and the zero-sequence voltages are computed based on the obtained voltage and the current measurements, in particular from the respective voltage phasors. At third, the positive sequence angle index, $\delta_V^+$, and the zero-sequence angle index, $\delta_V^0$, are computed, in particular as follows:

$$\delta_V^+ = \angle V_2 - \angle \Delta V_1 \text{ and } \delta_V^0 = \angle V_2 - \angle V_0 \qquad (25)$$

wherein, $\Delta V_1 = V_1^f - V_1^{Pre}$. At fourth, the fault type is based on the computed $\delta_V^+$ and $\delta_V^0$, and the ranges of phase angles shown in Fig. 7, in particular by comparing the computed $\delta_V^+$ and $\delta_V^0$ to the ranges of phase angles shown in Fig. 7 and identifying in which of the ranges of phase angles the computed $\delta_V^+$ and $\delta_V^0$ are located. According to an embodiment, the zero-sequence currents are also further compared to a pre-set value, the criteria of which are summarized as follows:

1. IF $-90° < \delta_V^+ < 30°$ and $-90° < \delta_V^0 < 30°$ and $I_o > I_{th}$, then the fault is the AG fault.

2. IF $30° < \delta_V^+ < 150°$ and $150° < \delta_V^0 < 270°$ and $I_o > I_{th}$, then the fault is the BG fault.

3. IF $150° < \delta_V^+ < 270°$ and $\delta_V^0$ and $I_o > I_{th}$, then the fault is the CG fault.

4. IF $-30° < \delta_V^+ < 90°$ and $30° < \delta_V^0 < 150°$ and $I_o > I_{th}$, then the fault is the ABG fault.

5. IF $90° < \delta_V^+ < 210°$ and $-90° < \delta_V^0 < 30°$ and $I_o > I_{th}$, then the fault is the BCG fault.

6. IF $210° < \delta_V^+ < 330°$ and $150° < \delta_V^0 < 270°$ and $I_o > I_{th}$, then the fault is the CAG fault.

7. IF $-30° < \delta_V^+ < 90°$ and $I_o < I_{th}$, then the fault is the AB fault.

8. IF $90° < \delta_V^+ < 210°$ and $I_o < I_{th}$, then the fault is the BC fault.

9. IF $210° < \delta_V^+ < 330°$ and $I_o < I_{th}$, then the fault is the CA fault.

At fifth, three phase fault is identified based on $\Delta V_a$, $\Delta V_b$, $\Delta V_c$, and $I_o$, in particular by comparing $\Delta V_a$, $\Delta V_b$, $\Delta V_c$, and $I_o$, to respective pre-set values, more particularly by performing the following:

If ( $\Delta V_a > V_{th1}$ and $\Delta V_b > V_{th2}$ and $\Delta V_c > V_{th3}$ and $I_o < I_{th}$ ) then it is a three-phase fault wherein, $\Delta V_a = \left| V_a^f \right| - \left| V_a^{Pre} \right|$, $\Delta V_a = \left| V_a^f \right| - \left| V_a^{Pre} \right|$, and $\Delta V_c = \left| V_c^f \right| - \left| V_c^{Pre} \right|$. $Vt_{h1}$, $V_{th2}$, and $V_{th3}$ are threshold voltages for phase-A, phase-B, and phase-C, respectively. According to an embodiment, $Vt_{h1}$, $V_{th2}$, and $V_{th3}$ are zero. According to an embodiment, $Vt_{h1}$, $V_{th2}$, and $V_{th3}$ are set based on another parameter, in particular a rated voltage, more particularly with as a ratio, e.g., 2%, of the rated voltage. The protection system for the electrical power system is controlled based on the identified fault. $\delta_V^+$ and/or $\delta_V^0$ may be the plurality of phase angle deviations determined based on network models of the electrical power system during respective faults of at least three faults. At least three faults may comprise any combinations of at least three of the AG fault, BG fault, CG fault, ABG fault, BCG fault, CAG fault, AB fault, BC fault, and CA fault. Any combination of at least three of the zones shown in Fig.7a)-c) may be the at least three phase angle ranges determined based on the plurality of phase angle deviations, wherein the sum of the at least three phase angle ranges is an angle of complete rotation. The at least three phase angle ranges may comprise any one of the phase angle ranges shown in above criteria 1 to 9 set for $\delta_V^+$ and/or $\delta_V^0$ . $\delta_V^+$ and/or $\delta_V^0$ may be the plurality of further phase angle deviations determined based on network models of the electrical power system during respective faults of at least three faults. At least three further faults may comprise any combinations of at least three of the AG fault, BG fault, CG fault, ABG fault, BCG fault, CAG fault, AB fault, BC fault, and CA fault. Any combination of at least three of the zones shown in Fig.7a)-c) may be the at least three further phase angle ranges determined based on the plurality of further phase angle deviations, wherein the sum of the at least three further phase angle ranges is an angle of complete rotation. The at least three further phase angle ranges may comprise any one of the phase angle ranges shown in above criteria 1 to 9 set for $\delta_V^+$ and/or $\delta_V^0$ .

According to an embodiment, the plurality of phase angle deviations is different from the plurality of further phase angle deviations. According to an embodiment, the at least three faults are different from the at least three further faults. According to an embodiment, the at least three phase angle ranges are different from the at least three further phase angle ranges.

It is understood by the person skilled in the art that the term 'further' merely implies 'additional' and can thusly be interchangeably used as the 'second', as well as 'third', 'fourth', and so forth. That is, for instance, a plurality of phase angle deviations may be a plurality of first phase angle deviations and a plurality of further phase angle deviations may be a plurality of second phase angle deviations. It is noted that the first phase angle deviations may or may not be the same parameter ( $\delta_V^+$ and/or $\delta_V^0$ ) for the respective faults. It is further understood by the skilled person that the parameter succeeding the first and the second may be computed, i.e., for instance, a plurality of third phase angle deviations, a plurality of fourth phase angle deviations, and so forth may be computed.

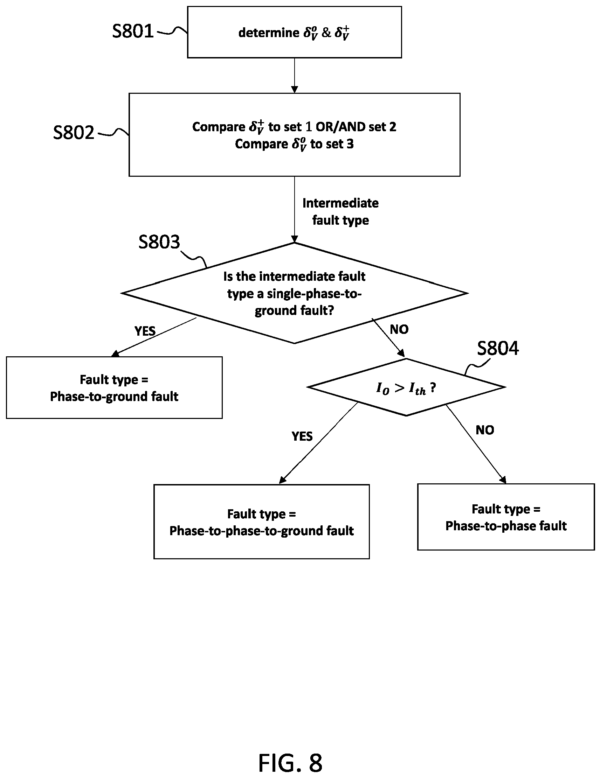

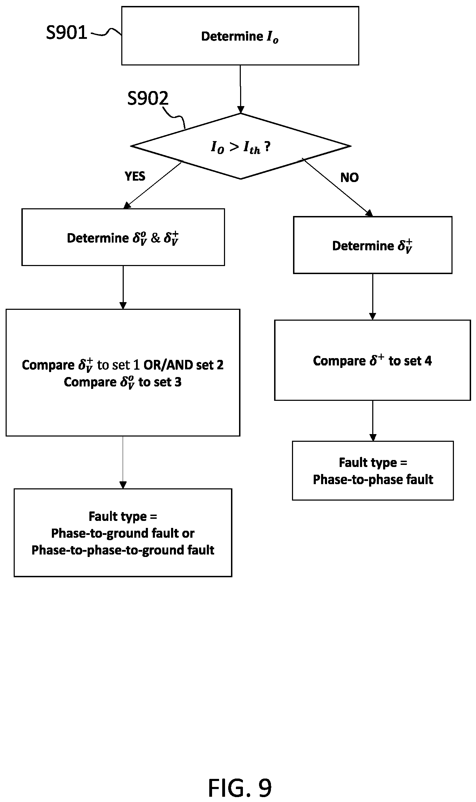

Fig. 8 and Fig. 9 illustrate further embodiments of the method for identifying a fault, in particular the fault type, based on the ranges of phase angles shown in Fig. 7.

In reference to Fig. 8, at S801, the positive sequence angle index, $\delta_V^+$ , and the zero-sequence angle index, $\delta_V^0$ , are computed, in particular according to eq.(25). The positive sequence angle index, $\delta_V^+$ , or the zero-sequence angle index, $\delta_V^0$ , may be referred to as a measured phase-angle deviation. According to an embodiment, S801 comprises obtaining the voltage and current measurements of a local terminal. According to an embodiment the local terminal is coupled to an asynchronous power source. According to an embodiment the local terminal is Bus M 251 of Fig. 2. According to an embodiment, S801 further comprises computing the positive sequence, the negative sequence, and the zero-sequence voltages based on the obtained voltage and the current measurements, in particular from the respective voltage phasors. At S802, $\delta_V^+$ is compared to set 1 and/or set 2, wherein set 1 is or comprises ranges of phase angle $\delta_V^+$ for single-phase-to-ground faults, wherein set 2 is or comprises ranges of phase angle $\delta_V^+$ for phase-to-phase-to-ground faults, and $\delta_V^0$ is compared to set 3, wherein set 3 is or comprises ranges of phase angle $\delta_V^0$ for single-phase-to-ground faults and phase-to-phase-to-ground faults. According to an embodiment, set 1, set 2, and set 3 are zones of Fig. 7a), Fig. 7b), and Fig. 7c), respectively. According to an embodiment, the comparing $\delta_V^+$ to set 1 and/or set 2 and comparing $\delta_V^0$ to set 3 is or comprises determining in which of the ranges of the respective set $\delta_V^+$ and $\delta_V^0$ are located. The intermediate fault type comprises information whether the fault involves a single phase, i.e. a single-phase-to-ground fault, or involves at least two phases, i.e. a phase-to-phase-to-ground fault or a phase-to-phase fault. For instance, when $\delta_V^+ = 50°$ and $\delta_V^0 = 200°$, comparing $\delta_V^+$ to Fig. 7a) indicates that the fault may be a BG fault, but comparing $\delta_V^+$ to Fig. 7b) indicates that the fault may be an ABG fault, and comparing $\delta_V^0$ to set 3 indicates that the fault may be either a BG or CAG fault. The fault is determined when the potential faults determined by $\delta_V^+$ comparison and $\delta_V^0$ comparison overlap with one another, in this case a BG fault. Accordingly, at S803, whether the identified intermediate fault type is a single-phase-to-ground fault is determined. In the affirmative, the fault is a phase-to-ground fault indicated at the intermediate fault type. In the negative however, the zero-sequence current may be compared to a threshold value at S804 to distinguish whether the fault is a phase-to-phase-to-ground fault or a phase-to-phase fault.

According to an embodiment, the transmission line is terminated by a first terminal coupled to a first generator and by a second terminal coupled to a second generator, the method further comprising: obtaining a plurality of voltage measurements of the first terminal; determining a measured phase-angle deviation based on the plurality of voltage measurements; and determining a fault by identifying in which of the at least three phase angle ranges the measured phase-angle deviation is located, in particular by comparing the measured phase-angle deviation to at least one of the at least three phase angle ranges.

According to an embodiment, the method further comprises: determining a plurality of further phase angle deviations based on the network models of the electrical power system during the respective faults of at least three further faults; and determining at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

According to an embodiment, the method further comprises: obtaining a plurality of voltage measurements of the first terminal; determining a further measured phase-angle deviation based on the plurality of voltage measurements; and determining the fault by identifying in which of the at least three further phase angle ranges the measured phase-angle deviation is located, in particular by comparing the measured phase-angle deviation to at least one of the at least three further phase angle ranges.

According to an embodiment, the method further comprises: obtaining a plurality of current measurements of the first terminal; determining a zero-sequence current based on the plurality of current measurements of the first terminal; and determining the fault based further on the zero-sequence current, in particular by comparing a zero-sequence current to a pre-set value.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, the method comprising: obtaining a plurality of voltage measurements of the first terminal measured before a fault and during the fault; and determining a n-phase fault based on voltage differences between respective phases of the plurality of voltage measurements measured before the fault and the plurality of voltage measurements measured during the fault, wherein n is a natural number, larger than 1, corresponding to the number of the plurality of phases.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

According to an embodiment, the transmission line is terminated by a first terminal coupled to a first generator and by a second terminal coupled to a second generator, the method further comprising: obtaining a plurality of voltage measurements of the first terminal; determining a measured phase-angle deviation based on the plurality of voltage measurements; determining a fault by identifying in which of the at least three phase angle ranges the measured phase-angle deviation is located, in particular by comparing the measured phase-angle deviation to at least one of the at least three phase angle ranges; and controlling the protection system for the electrical power system based on the determined fault. According to an embodiment, the measured phase-angle deviation is the positive sequence angle index, $\delta_V^+$, or the zero-sequence angle index, $\delta_V^0$ of eq.(25). According to an embodiment, at least three faults or at least three further faults are or comprise faults involving a single phase, in particular phase-to-ground faults, more particularly, AG, BG, and CG faults. According to an embodiment, at least three faults or at least three further faults are or comprise faults involving two phases, in particular phase-to-phase-to-grounds faults, more particularly ABG, BCG, and CAG faults, and/or phase-to-phase faults, more particularly AB, BC, and CA faults. According to an embodiment, at least three faults or at least three further faults are or comprise any possible combination of at least three of the above-mentioned faults. According to an embodiment, the at least three faults are the same as the at least three further faults. According to an embodiment, the at least three faults are different from the at least three further faults. According to an embodiment, the at least three phase angle ranges are or comprise the zones 1, 2, and 3 of Fig. 7a) or zones 1, 2, and 3 of Fig. 7c). According to an embodiment, the at least three second phase angle ranges are or comprise the zones 1, 2, and 3 of Fig. 7b) or zones 1, 2, and 3 of Fig. 7c).

According to an embodiment, the method further comprises: determining a plurality of further phase angle deviations based on the network models of the electrical power system during the respective faults of at least three further faults; and determining at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

According to an embodiment, the method further comprises: obtaining a plurality of voltage measurements of the first terminal; determining a further measured phase-angle deviation based on the plurality of voltage measurements; determining the fault by identifying in which of the at least three further phase angle ranges the measured phase-angle deviation is located, in particular by comparing the measured phase-angle deviation to at least one of the at least three further phase angle ranges; and controlling the protection system for the electrical power system based on the determined fault. According to an embodiment, the further measured phase-angle deviation is the positive sequence angle index, $\delta_V^+$, or the zero-sequence angle index, $\delta_V^0$ of eq.(25). According to an embodiment, the at least three further phase angle ranges are or comprise the zones 1, 2, and 3 of Fig. 7a) or zones zones 1, 2, and 3 of Fig. 7c). According to an embodiment, the at least three second phase angle ranges are or comprise the zones 1, 2, and 3 of Fig. 7b) or zones zones 1, 2, and 3 of Fig. 7c).

According to an embodiment, the method further comprises: obtaining a plurality of current measurements of the first terminal; determining a zero-sequence current based on the plurality of current measurements of the first terminal; determining the fault based further on the zero-sequence current, in particular by comparing a zero-sequence current to a preset value; and controlling the protection system for the electrical power system based on the determined fault. According to an embodiment, the determining the fault based on the zero-sequence current is S804 of Fig. 8 and/or at least any one of above-numbered criteria 1 to 9.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault. According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line. According to an embodiment, the first phase angle is $\angle V_2$ of eq.(25). According to an embodiment, the second phase angle is $\angle \Delta V_1$ or $\angle V_0$ of eq.(25). According to an embodiment, the transmission line carries a plurality of phases, the method comprising: obtaining a plurality of voltage measurements of the first terminal measured before a fault and during the fault; determining a n-phase fault based on voltage differences between respective phases of the plurality of voltage measurements measured before the fault and the plurality of voltage measurements measured during the fault, wherein n is a natural number, larger than 1, corresponding to the number of the plurality of phases; and controlling the protection system is further based on the determined n-phase fault.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

In reference to Fig. 9, at S901, the zero-sequence current is determined. At S902, the zero-sequence is compared to a pre-set value. In the affirmative, S801 and S802 are performed to determine the fault type to be a phase-to-ground fault or a phase-to-phase-to-ground fault. In the negative, $\delta_V^+$ is determined and compared to set 4, wherein set 4 is or comprises ranges defined by criteria numbered 7 to 9 for $\delta_V^+$. The determined fault type is a phase-to-phase fault.

According to an embodiment, the method further comprises: determining a plurality of further phase angle deviations based on the network models of the electrical power system during the respective faults of at least three further faults; determining at least three further phase angle ranges based on the further plurality of phase angle deviations, wherein a sum of the at least three further phase angle ranges is an angle of complete rotation; determining a further measured phase-angle deviation based on the plurality of voltage measurements; and determining the fault by identifying in which of the at least three further phase angle ranges the measured phase-angle deviation is located, in particular by comparing the measured phase-angle deviation to at least one of the at least three further phase angle ranges.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault. According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the method further comprises: obtaining a plurality of voltage measurements of the first terminal measured before a fault and during the fault; and determining a n-phase fault based on voltage differences between respective phases of the plurality of voltage measurements measured before the fault and the plurality of voltage measurements measured during the fault, wherein n is a natural number, larger than 1, corresponding to the number of the plurality of phases.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

According to an embodiment, the method further comprises: determining a plurality of further phase angle deviations based on the network models of the electrical power system during the respective faults of at least three further faults; determining at least three further phase angle ranges based on the further plurality of phase angle deviations, wherein a sum of the at least three further phase angle ranges is an angle of complete rotation; determining a further measured phase-angle deviation based on the plurality of voltage measurements; determining the fault by identifying in which of the at least three further phase angle ranges the measured phase-angle deviation is located, in particular by comparing the measured phase-angle deviation to at least one of the at least three further phase angle ranges; and controlling the protection system for the electrical power system based on the determined fault. According to an embodiment, the at least three faults or at least three further faults are or comprise faults involving two phases, in particular phase-to-phase-to-grounds faults, more particularly ABG, BCG, and CAG faults, and/or phase-to-phase faults, more particularly AB, BC, and CA faults. According to an embodiment, the at least three faults or at least three further faults are or comprise faults involving a single phase, in particular phase-to-ground faults, more particularly, AG, BG, and CG faults. According to an embodiment, at least three faults or at least three further faults are or comprise faults comprising any possible combination of at least three of the above-mentioned faults. According to an embodiment, the at least three faults are the same as the at least three further faults. According to an embodiment, the at least three faults are different from the at least three further faults. According to an embodiment, the at least three phase angle ranges are or comprise the zones 1, 2, and 3 of Fig. 7a) or zones 1, 2, and 3 of Fig. 7c). According to an embodiment, the at least three second phase angle ranges are or comprise the zones 1, 2, and 3 of Fig. 7b) or zones 1, 2, and 3 of Fig. 7c).

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the method further comprises: obtaining a plurality of voltage measurements of the first terminal measured before a fault and during the fault; determining a n-phase fault based on voltage differences between respective phases of the plurality of voltage measurements measured before the fault and the plurality of voltage measurements measured during the fault, wherein n is a natural number, larger than 1, corresponding to the number of the plurality of phases; and controlling the protection system is further based on the determined n-phase fault.

According to an embodiment, the method further comprises obtaining a plurality of current measurements of the first terminal; determining a generator type of the first generator based on the plurality of current measurements and/or the plurality of voltage measurements; and determining the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

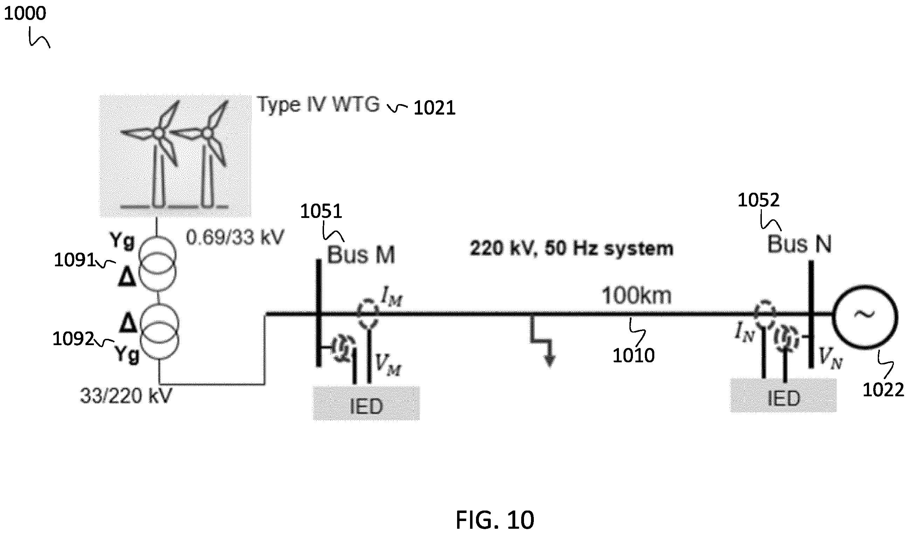

Fig.10 illustrates a power system under test according to an embodiment of the present disclosure. The network 1000 comprises a first power source 1021 connected to a second power source 1022 via a transmission line 1010. In this embodiment, the first power source 1021 is an asynchronous power source, in particular Type IV wind turbine generator, WTG, and the second power source 1022 is a power grid modelled as a Thevenin equivalent (constant voltage source behind a source impedance) beyond bus N 1052. According to an embodiment, the first power source and/or the second power source may be a synchronous source. The transmission line 1010 is terminated by a first terminal 1051, Bus M in this embodiment, and a second terminal 1052, Bus N in this embodiment. According to an embodiment, the transmission line is terminated by a further terminal such as a third terminal, a fourth terminal, and so on. The WTG 1021 is coupled to Bus M 1051 via a wye-delta transformer 1091 and a delta-wye transformer 1092. An intelligent electronic device, IED, may be placed at, in, or on or associated with Bus M 1051. According to an embodiment, the IED measures voltage and current of Bus M 1051. An intelligent electronic device, IED, may be placed at, in, or on or associated with Bus N 1052. According to an embodiment, the IED measures voltage and current of Bus N 1052. According to an embodiment, the IED placed at, in, or on or associated with Bus N 1052 is omitted. The power flows from the first power source 1021 through the line 1010 between bus M 1051 and bus N 1052, which in this case is a 100 km long line operated at a nominal voltage of 220 kV.

The following illustrate three fault cases and the identification method according to an embodiment of the present disclosure.

• Case 1: AG fault at 10km from Bus M 1051, RF=10Ω, and fault inception angle, FIA=60°:

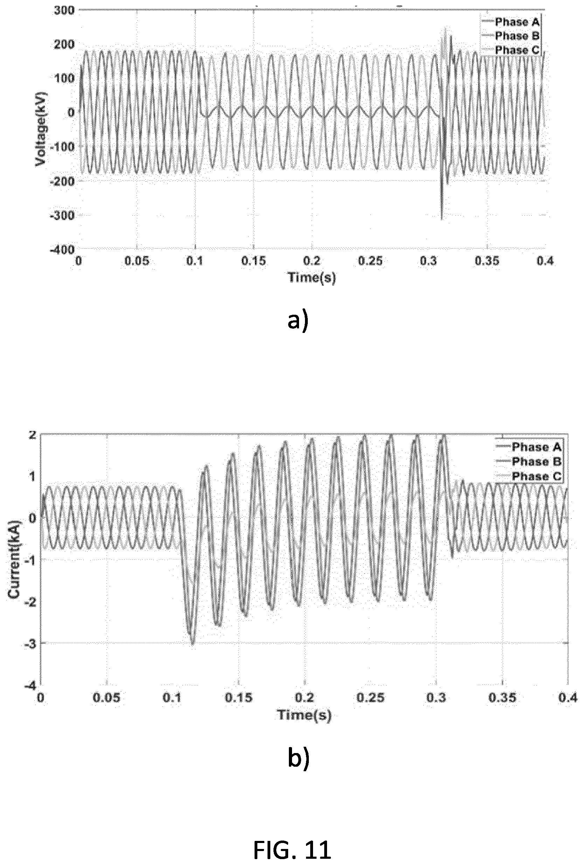

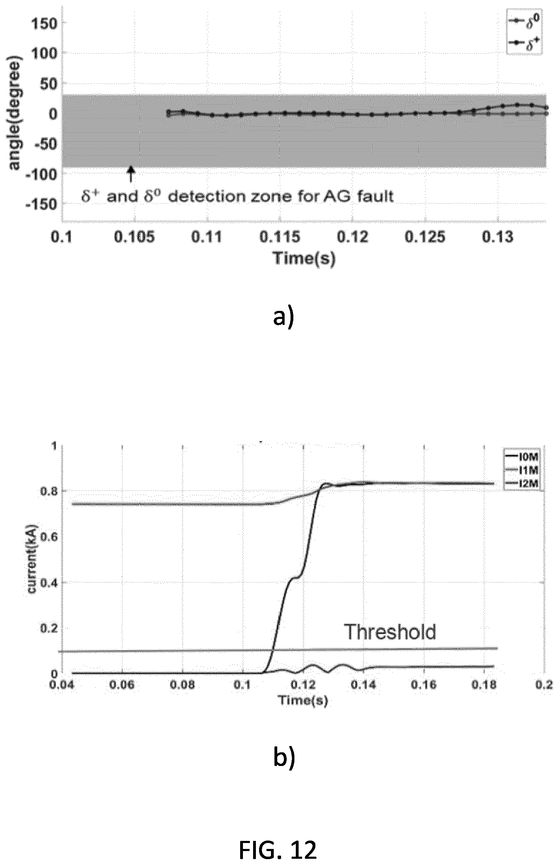

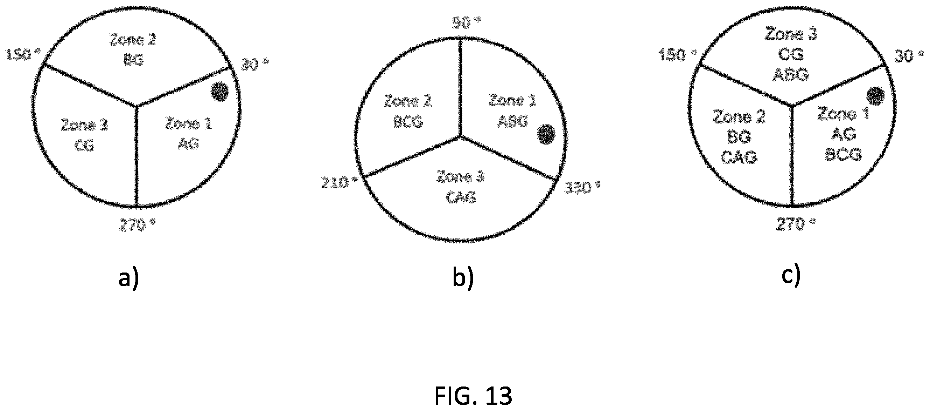

For this case, the 3-phase voltage and current measurements of bus M 1051 is shown in Fig. 11a) and Fig.11 b), respectively. From this figure, pattern of AG fault is shown. The fault occurs at 0.1s and lasts for 0.22s. The positive sequence and zero-sequence index are calculated at different time instances as shown in Fig. 12a), which fall within the defined AG fault zone of $270° < \delta_V^0 < 30°$ and $270° < \delta_V^+ < 30°$. This is also evident from Fig. 13a) to Fig. 13c) which illustrate the phase angle ranges of $\delta_V^+$ for phase-to-ground faults, the phase angle ranges of $\delta_V^+$ for phase-to-phase-to-ground faults, the phase angle ranges of $\delta_V^0$ phase-to-ground faults and phase-to-phase-to-ground faults, and the location of the computed $\delta_V^+$ and $\delta_V^0$ therein, as indicated by the block dots. The location of the black dots in Fig. 13a)_to Fig. 13c) corresponds to the values of $\delta_V^0$ and $\delta_V^+$ at a time instance after fault, e.g., 20ms after the fault has occurred. The zero-sequence current is greater than the threshold ($I_0 > I_{th}$) as shown in Fig. 12b). Thus, the fault is determined to be an AG fault.

• Case 2: AB fault at 10km from Bus M 1051, RF=50Ω, and FIA=60°:

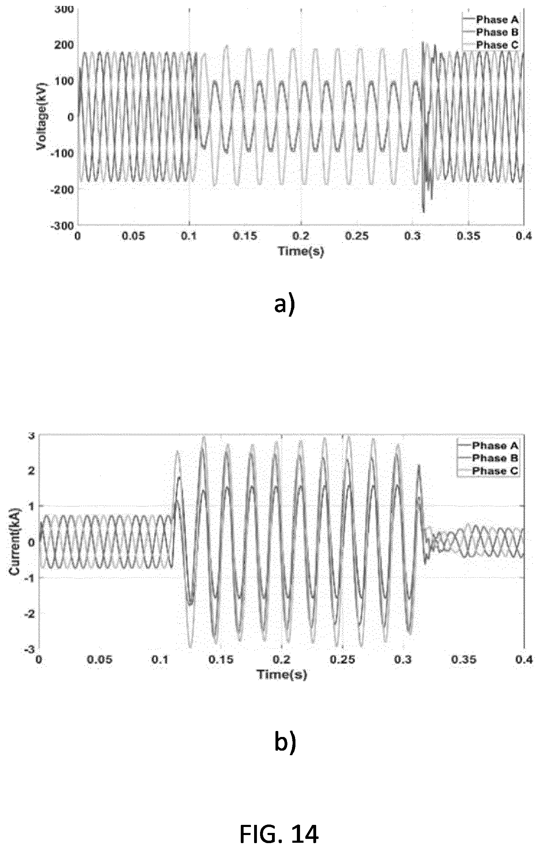

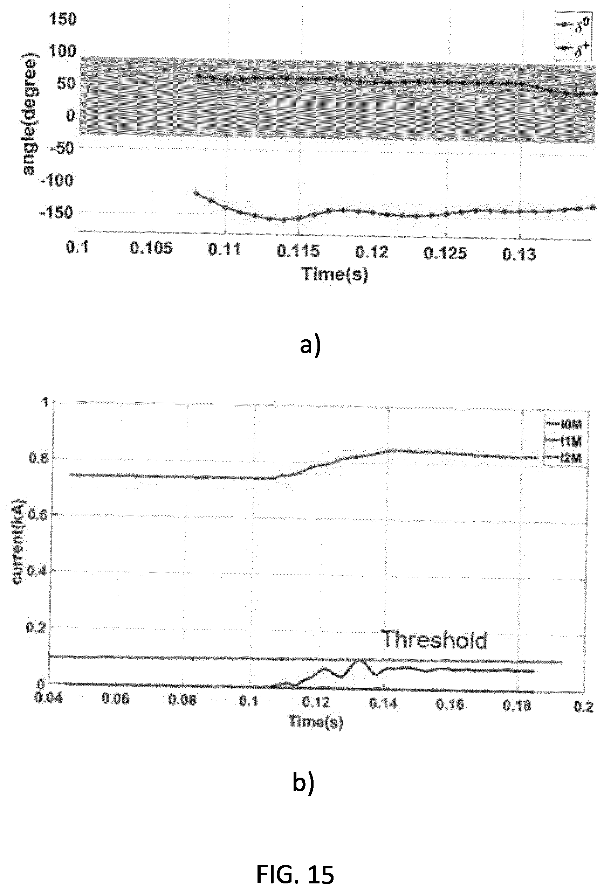

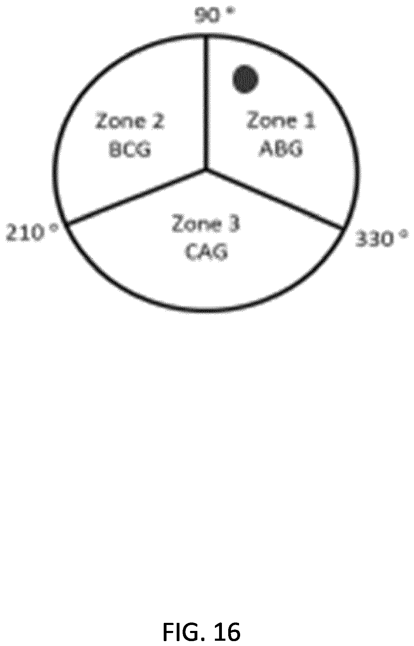

For this case, the 3-phase voltages and current measurements of bus M 1051 is shown in Fig. 14a) and Fig. 14b), respectively. The positive sequence and zero-sequence index are calculated at different time instances as shown in Fig. 15a), which fall within the defined AB fault zone of and $330° < \delta_V^+ < 90°$. The zero-sequence current is less than the threshold ($I_0 < I_{th}$) as shown in Fig. 15b). Thus, the fault is determined to be an AB fault. In this embodiment, the phase angle ranges of $\delta_V^+$ for phase-to-phase faults are equal to the respective phase angle ranges of $\delta_V^+$ for phase-to-phase-to-ground faults, as evident from above-described criteria numbered 4 to 6 and 7 to 9. Thus, Fig. 16 illustrates the phase angle ranges of $\delta_V^+$ for phase-to-phase-to-ground faults and the location of the computed $\delta_V^+$ therein.

• Case 3: BCG fault at 10km from Bus M 1051, RF=10Ω, and FIA=60°:

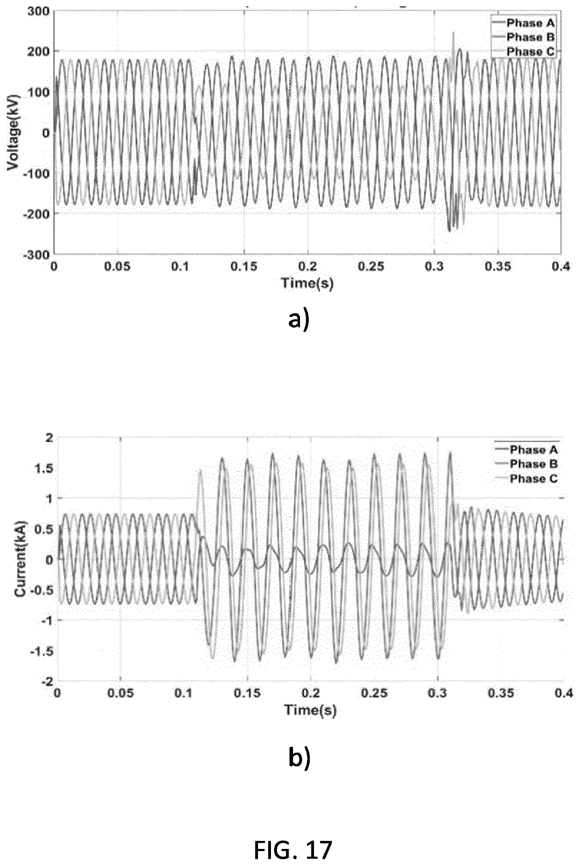

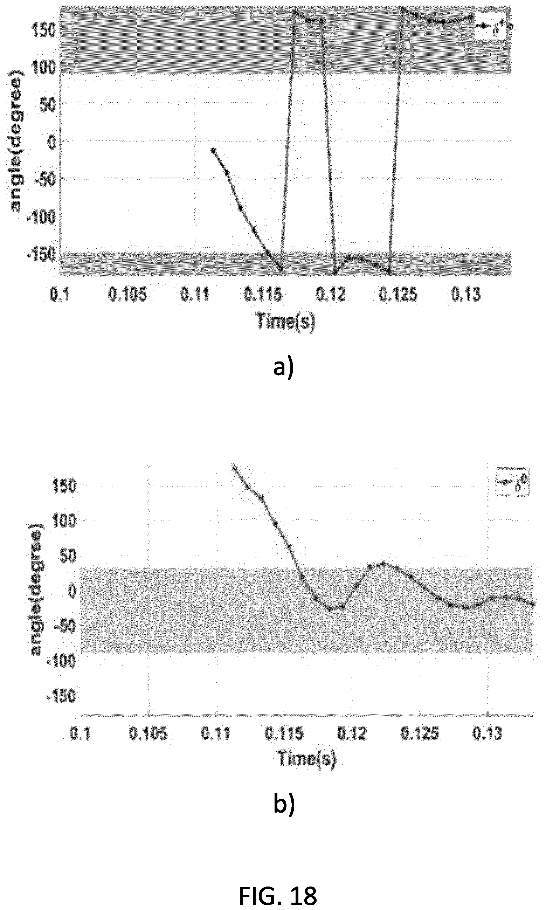

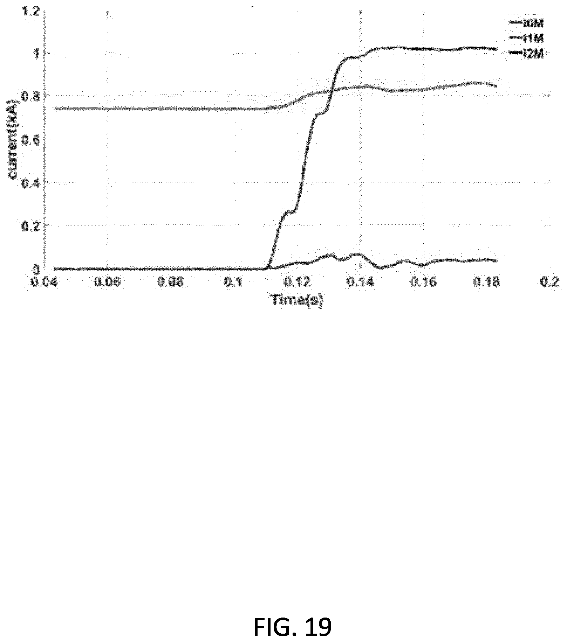

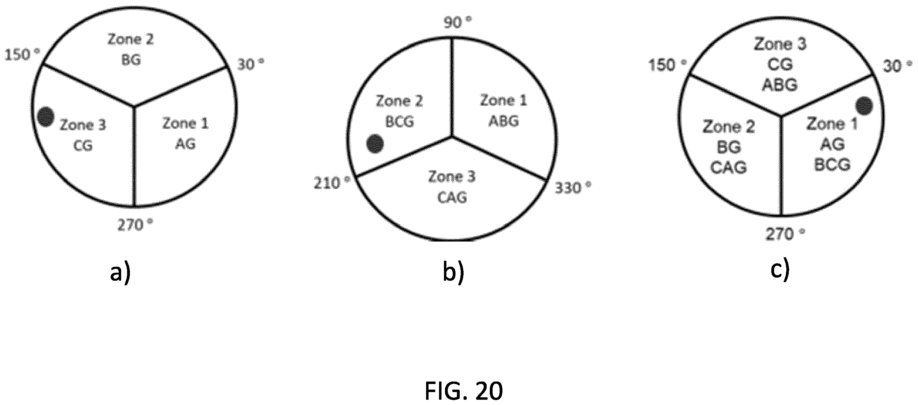

For this case, the 3-phase voltages and current measurements of bus M 1051 is shown in Fig. 17a) and Fig. 17b), respectively. The positive sequence and zero-sequence index are calculated at different time instances as shown in Fig. 18a) and Fig. 18b), respectively, each of which is within the defined BCG fault zone of $90° < \delta_V^+ < 210°$ and $270° < \delta_V^0 < 30°$. This is also evident from Fig. 20a) to Fig. 20c) which illustrate the phase angle ranges of $\delta_V^+$ for phase-to-ground faults, the phase angle ranges of $\delta_V^+$ for phase-to-phase-to-ground faults, the phase angle ranges of $\delta_V^0$ phase-to-ground faults and phase-to-phase-to-ground faults, and the location of the computed $\delta_V^+$ and $\delta_V^0$ therein, as indicated by the block dots. The zero-sequence current is greater than the threshold ($I_0 > I_{th}$) as shown in Fig. 19. Thus, the fault is determined to be an BCG fault.

The following illustrate testing results for various system configurations including a single circuit, a double circuit, and a cable system with various CIRPPs installations including Type III WTG, Type IV WTG, and solar photovoltaic (PV) generator.

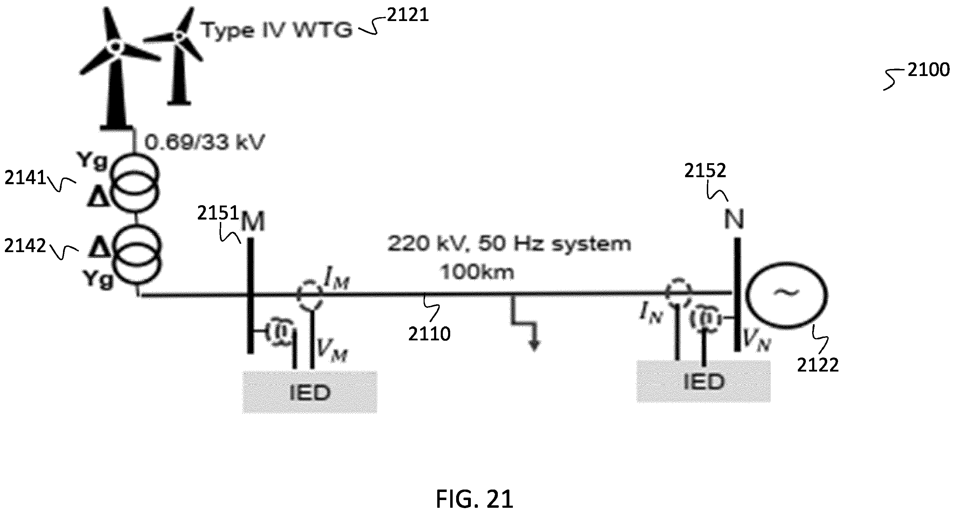

• System configuration: Single circuit transmission line with type IV WTG (Fig. 21)

The network 2100 comprises a first power source 2121 connected to a second power source 2122 via a transmission line 2110. In this embodiment, the first power source 2121 is an asynchronous power source, in particular Type IV wind turbine generator, WTG, and the second power source 2122 is a power grid modelled as a Thevenin equivalent (constant voltage source behind a source impedance) beyond bus N 2152. According to an embodiment, the first power source and/or the second power source may be a synchronous source. The transmission line 2110 is terminated by a first terminal 2151, Bus M in this embodiment, and a second terminal 2152, Bus N in this embodiment. According to an embodiment, the transmission line is terminated by a further terminal such as a third terminal, a fourth terminal, and so on. The WTG 2121 is coupled to Bus M 2151 via a wye-delta transformer 2141 and a delta-wye transformer 2142. An intelligent electronic device, IED, may be placed at, in, or on or associated with Bus M 2151. According to an embodiment, the IED measures voltage and current of Bus M 2151. An intelligent electronic device, IED, may be placed at, in, or on or associated with Bus N 2152. According to an embodiment, the IED measures voltage and current of Bus N 2152. According to an embodiment, the IED placed at, in, or on or associated with Bus N 2152 is omitted. The power flows from the first power source 2121 through the line 2110 between bus M 2151 and bus N 2152. The following lists test conditions, system parameters, and the WTG parameters.

Total number of test cases = 660

Test conditions:

1. Fault inception angles: 0°, 60°, 135°

2. Fault resistance: 0, 5, 10, 20, 50 $\Omega$

3. Source-to-line-impedance ratio, SIR, at grid side: 0.5

4. Fault type: A-g, AB, BC-g, ABC-g

5. Fault location: 1%, 5%, 10%, 16%, 24%, 36%, 50%, 64%, 76%, 84%, 90%

System parameters:

6. Line MN: - $Z_L^+$ ($\Omega$/km) = 0.036 + j0.198 , $Z_L^0$ ($\Omega$/km) = 0.2625 + j0.862

7. Source at Bus N
Source angle = -17.1°

$$Z_S^+ = 35\angle 83°$$

$$Z_S^0 = 15\angle 85°$$

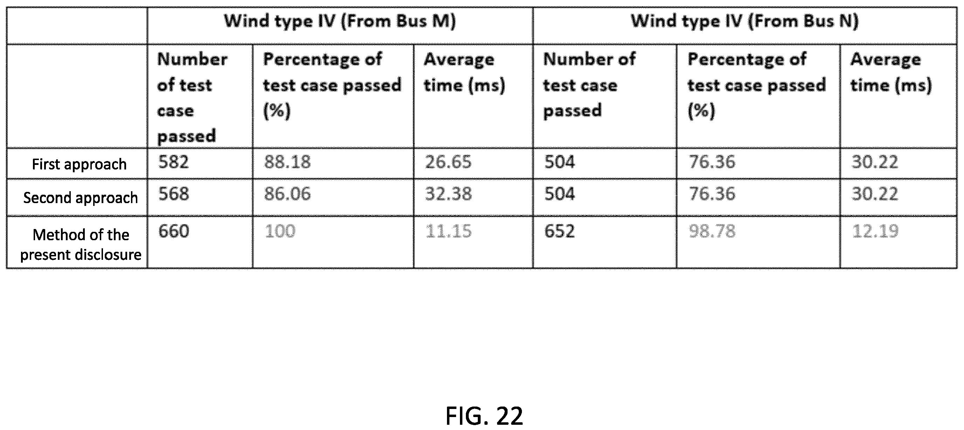

Fig. 22 illustrates a performance summary of the method according to an embodiment of the present disclosure. In particular, the performance summary includes the performances of a first approach and a second approach for a comparative purpose.

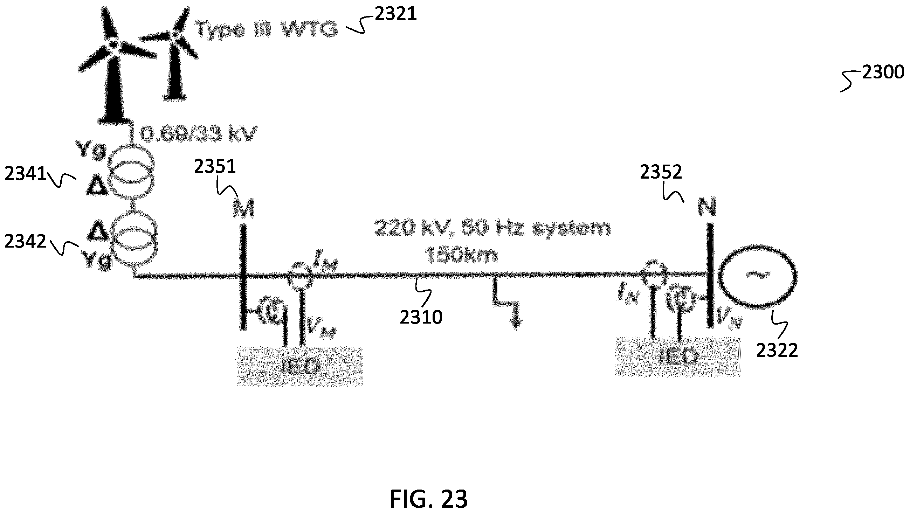

• System configuration: Single circuit transmission line with wind type III (Fig. 23)

The network 2300 comprises a first power source 2321 connected to a second power source 2322 via a transmission line 2310. In this embodiment, the first power source 2321 is an asynchronous power source, in particular Type III wind turbine generator, WTG, and the second power source 2322 is a power grid modelled as a Thevenin equivalent (constant voltage source behind a source impedance) beyond bus N 2352. According to an embodiment, the first power source and/or the second power source may be a synchronous source. The transmission line 2310 is terminated by a first terminal 2351, Bus M in this embodiment, and a second terminal 2352, Bus N in this embodiment. According to an embodiment, the transmission line is terminated by a further terminal such as a third terminal, a fourth terminal, and so on. The WTG 2321 is coupled to Bus M 2351 via a wye-delta transformer 2341 and a delta-wye transformer 2342. An intelligent electronic device, IED, may be placed at, in, or on or associated with Bus M 2351. According to an embodiment, the IED measures voltage and current of Bus M 2351. An intelligent electronic device, IED, may be placed at, in, or on or associated with Bus N 2352. According to an embodiment, the IED measures voltage and current of Bus N 2352. According to an embodiment, the IED placed at, in, or on or associated with Bus N 2352 is omitted. The power flows from the first power source 2321 through the line 2310 between bus M 2351 and bus N 2352. The following lists test conditions, system parameters, and the WTG parameters.

Total number of test cases = 528

Test conditions:

1. Fault inception angles: 0°, 60°, 135°

2. Fault resistance: 0, 10, 20, 50 $\Omega$

3. SIR at grid side: 0.5

4. Fault type: A-g, AB, BC-g, ABC-g

5. Fault location: 1%, 5%, 10%, 16%, 24%, 36%, 50%, 64%, 76%, 84%, 90%

System parameters:

6. Line MN: - $Z_L^+$ ($\Omega$/km) = 0.036 + j0.198 , $Z_L^0$ ($\Omega$/km) = 0.2625 + j0.862

7. Source at Bus N
Source angle = -17.1°

$$Z_S^+ = 35\angle 83°$$

$$Z_S^0 = 15\angle 85°$$

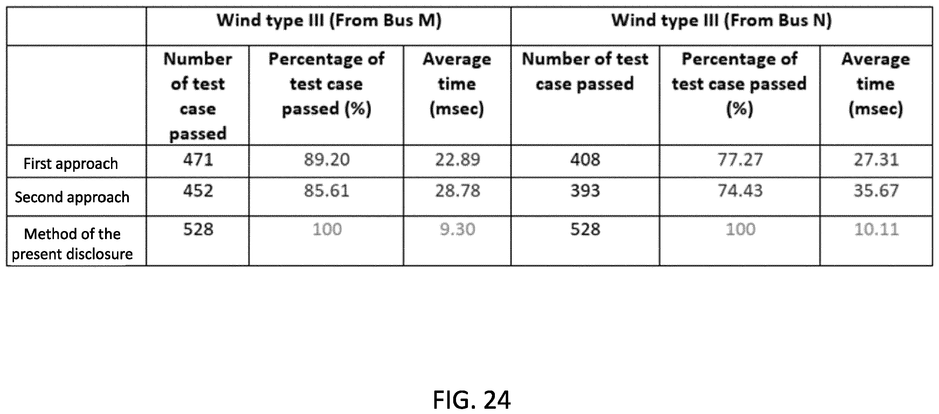

Fig. 24 illustrates a performance summary of the method according to an embodiment of the present disclosure. In particular, the performance summary includes the performances of a first approach and a second approach for a comparative purpose.

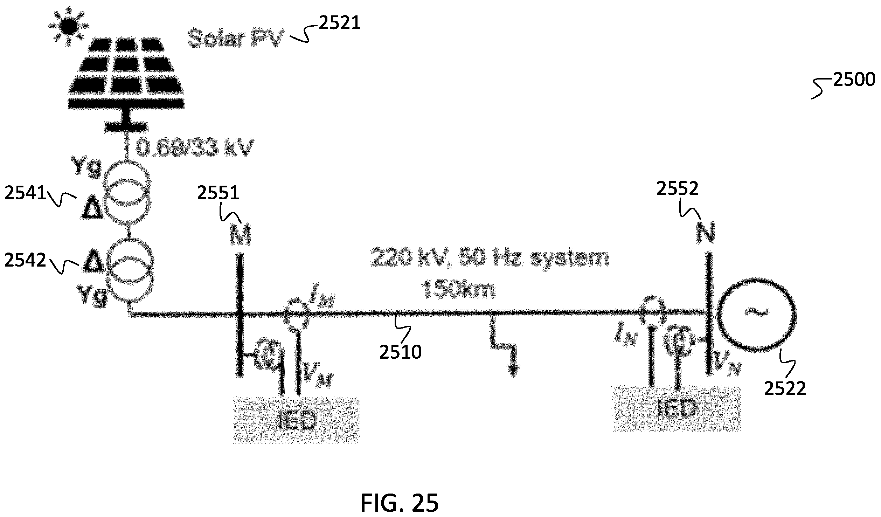

• System configuration: Single circuit transmission line with solar PV generator (Fig. 25)

The network 2500 comprises a first power source 2521 connected to a second power source 2522 via a transmission line 2510. In this embodiment, the first power source 2521 is an asynchronous power source, in particular a solar PV and the second power source 2522 is a power grid modelled as a Thevenin equivalent (constant voltage source behind a source impedance) beyond bus N 2552. According to an embodiment, the first power source and/or the second power source may be a synchronous source. The transmission line 2510 is terminated by a first terminal 2551, Bus M in this embodiment, and a second terminal 2552, Bus N in this embodiment. According to an embodiment, the transmission line is terminated by a further terminal such as a third terminal, a fourth terminal, and so on. The solar PV 2521 is coupled to Bus M 2551 via a wye-delta transformer 2541 and a delta-wye transformer 2542. An intelligent electronic device, IED, may be placed at, in, or on or associated with Bus M 2351. According to an embodiment, the IED measures voltage and current of Bus M 2551. An intelligent electronic device, IED, may be placed at, in, or on or associated with Bus N 2552. According to an embodiment, the IED measures voltage and current of Bus N 2552. According to an embodiment, the IED placed at, in, or on or associated with Bus N 2552 is omitted. The power flows from the first power source 2521 through the line 2510 between bus M 2551 and bus N 2552. The following lists test conditions, system parameters, and the solar PV parameters.
Total number of test cases = 528

Test conditions:

1. Fault inception angles: 0°, 60°, 135°

2. Fault resistance: 0, 10, 20, 50 $\Omega$

3. SIR at grid side: 0.5

4. Fault type: A-g, AB, BC-g, ABC-g

5. Fault location: 1%, 5%, 10%, 16%, 24%, 36%, 50%, 64%, 76%, 84%, 90%

System parameters:

6. Line MN: $- Z_L^+$ (Ω/km) = 0.036 + j0.198 , $Z_L^0$ (Ω/km) = 0.2625 + j0.862

7. Source at Bus N
Source angle = -17.1°

$$Z_S^+ = 35\angle 83°$$

$$Z_S^0 = 15\angle 85°$$

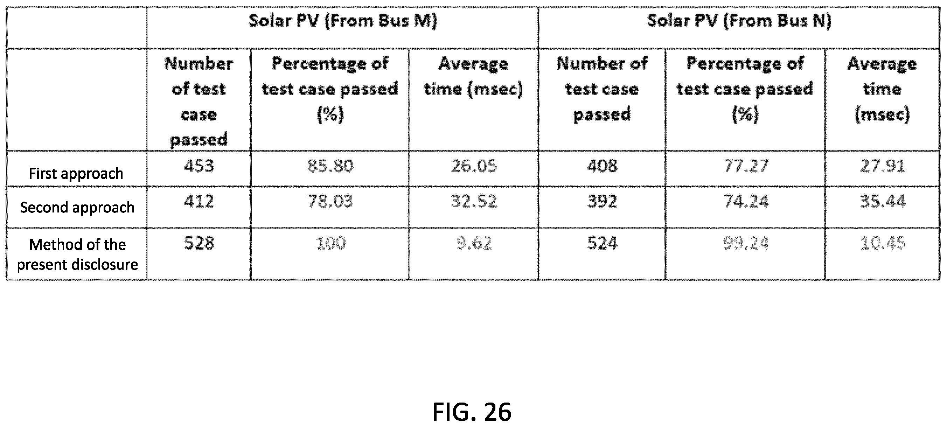

Fig. 26 illustrates a performance summary of the method according to an embodiment of the present disclosure. In particular, the performance summary includes the performances of a first approach and a second approach for a comparative purpose.

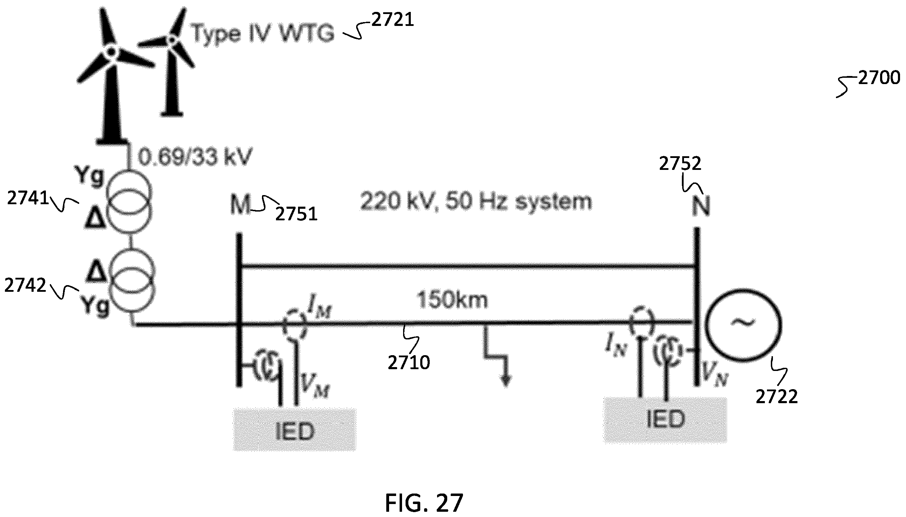

• System configuration: Double circuit transmission line with wind type IV (Fig. 27)

The network 2700 comprises a first power source 2721 connected to a second power source 2722 via a transmission line 2710. The transmission line 2710 is a double circuit transmission line. In this embodiment, the first power source 2721 is an asynchronous power source, in particular a Type IV wind turbine generator, WTG, and the second power source 2722 is a power grid modelled as a Thevenin equivalent (constant voltage source behind a source impedance) beyond bus N 2752. According to an embodiment, the first power source and/or the second power source may be a synchronous source. The transmission line 2710 is terminated by a first terminal 2751, Bus M in this embodiment, and a second terminal 2752, Bus N in this embodiment. According to an embodiment, the transmission line is terminated by a further terminal such as a third terminal, a fourth terminal, and so on. The WTG 2721 is coupled to Bus M 2751 via a wye-delta transformer, in particular a grounded wye-delta transformer, 2741 and a delta-wye transformer, in particular a grounded delta-wye transformer, 2742. An intelligent electronic device, IED, may be placed at, in, or on or associated with Bus M 2751. According to an embodiment, the IED measures voltage and current of Bus M 2751. An intelligent electronic device, IED, may be placed at, in, or on or associated with Bus N 2752. According to an embodiment, the IED measures voltage and current of Bus N 2752. According to an embodiment, the IED placed at, in, or on or associated with Bus N 2752 is omitted. The power flows from the first power source 2721 through the line 2710 between bus M 2751 and bus N 2752. The following lists test conditions, system parameters, and the Type IV WTG parameters.
Total number of test cases = 528

Test conditions:

1. Fault inception angles: 0°, 60°, 135°

2. Fault resistance: 0, 10, 20, 50 Ω

3. SIR at grid side: 0.5, 2

4. Fault type: A-g, AB, BC-g, ABC-g

5. Fault location: 1%, 5%, 10%, 16%, 24%, 36%, 50%, 64%, 76%, 84%, 90%

System parameters:

6.     Line     MN: $- Z_L^+$ (Ω /km) = 0.032 + j0.261, $Z_L^0$ (Ω /km) = 0.280 + j1.148 ,

$$Z_L^{0m} \ (\Omega/km) = 0.248 + j0.776$$

7. Source at Bus N
Source angle = -17.1°

$$Z_S^+ = 35\angle 83°$$

$$Z_S^0 = 15\angle 85°$$

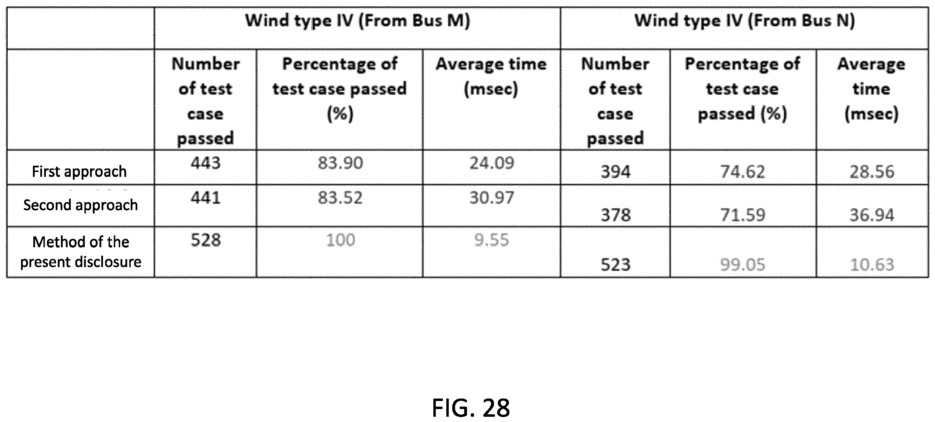

Fig. 28 illustrates a performance summary of the method according to an embodiment of the present disclosure. In particular, the performance summary includes the performances of a first approach and a second approach for a comparative purpose.

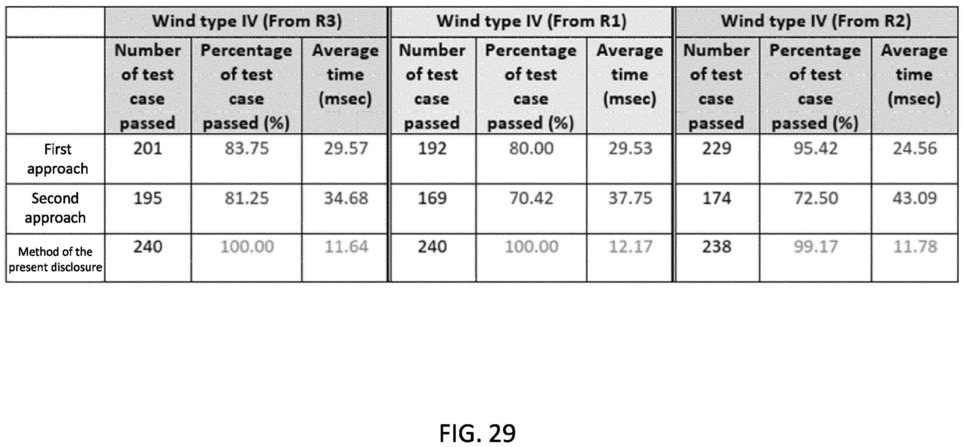

Fig. 29 illustrates a performance summary of the method according to an embodiment of the present disclosure. In particular, the performance summary includes the performances of a first approach and a second approach for a comparative purpose.

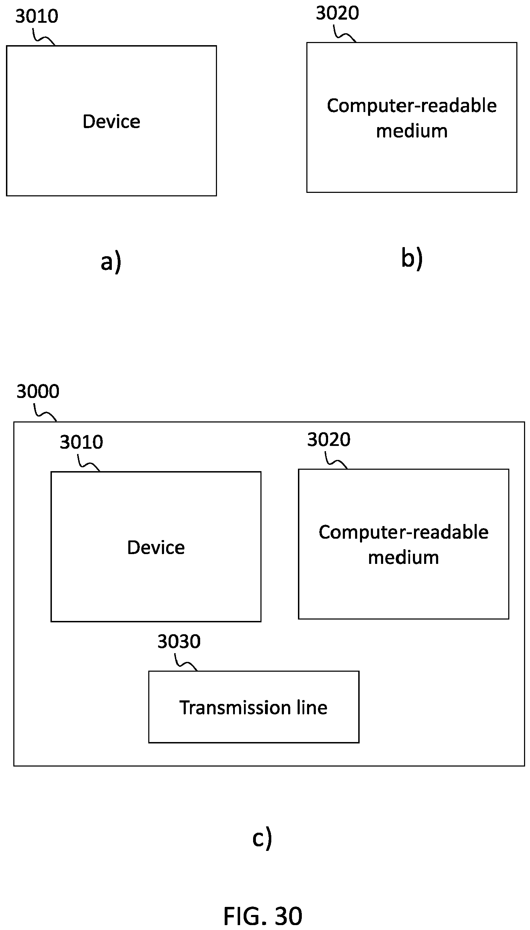

Fig. 30 illustrates a device, a computer-readable medium, and a system according to an embodiment of the present disclosure. The device 3010 is a device for controlling a protection system for an electrical power system comprising a transmission line. The computer-readable medium 3020 is a device for controlling a protection system for an electrical power system comprising a transmission line, carrying instructions to perform the method of any one of the above-mentioned embodiments. The electrical power system 3000 comprising, the device 3010 of any one of the above-described embodiments, and a computer-readable medium 3020 of any one of the above-described embodiments.

According to an embodiment, the transmission line is terminated by a first terminal coupled to a first generator and by a second terminal coupled to a second generator, the processor is further configured to: obtain a plurality of voltage measurements of the first terminal; determine a measured phase-angle deviation based on the plurality of voltage measurements; determine a fault by identifying in which of the at least three phase angle ranges the measured phase-angle deviation is located, in particular by comparing the measured phase-angle deviation to at least one of the at least three phase angle ranges; and control the protection system for the electrical power system based on the determined fault.

According to an embodiment, the processor is further configured to: determine a plurality of further phase angle deviations based on the network models of the electrical power system during the respective faults of at least three further faults; and determine at least three further phase angle ranges based on the further plurality of phase angle deviations, wherein the plurality of phase angle deviations is different from the plurality of further phase angle deviations, wherein the at least three faults are different from the at least three further faults, wherein the at least three phase angle ranges are different from the at least three further phase angle ranges, and wherein a sum of the at least three further phase angle ranges is an angle of complete rotation.

According to an embodiment, the processor is further configured to: obtain a plurality of voltage measurements of the first terminal; determine a further measured phase-angle deviation based on the plurality of voltage measurements; determine the fault by identifying in which of the at least three further phase angle ranges the measured phase-angle deviation is located, in particular by comparing the measured phase-angle deviation to at least one of the at least three further phase angle ranges; and controlling the protection system for the electrical power system based on the determined fault.

According to an embodiment, the processor is further configured to: obtain a plurality of current measurements of the first terminal; determine a zero-sequence current based on the plurality of current measurements of the first terminal; determine the fault based further on the zero-sequence current, in particular by comparing a zero-sequence current to a preset value; and control the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, the processor is further configured to: obtain a plurality of voltage measurements of the first terminal measured before a fault and during the fault; determine a n-phase fault based on voltage differences between respective phases of the plurality of voltage measurements measured before the fault and the plurality of voltage measurements measured during the fault, wherein n is a natural number, larger than 1, corresponding to the number of the plurality of phases; and controlling the protection system is further based on the determined n-phase fault.

According to an embodiment, the processor is further configured to: obtain a plurality of current measurements of the first terminal; determine a generator type of the first generator based on the plurality of current measurements and/or the plurality of voltage measurements; and determine the measured phase-angle deviation based on the plurality of voltage measurements when the first generator is determined to be a first generator type; or determining the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

According to an embodiment, the processor is further configured to: determine a plurality of further phase angle deviations based on the network models of the electrical power system during the respective faults of at least three further faults; determine at least three further phase angle ranges based on the further plurality of phase angle deviations, wherein a sum of the at least three further phase angle ranges is an angle of complete rotation; determine a further measured phase-angle deviation based on the plurality of voltage measurements; determine the fault by identifying in which of the at least three further phase angle ranges the measured phase-angle deviation is located, in particular by comparing the measured phase-angle deviation to at least one of the at least three further phase angle ranges; and control the protection system for the electrical power system based on the determined fault.

According to an embodiment, the measured phase-angle deviation is a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is the phase angle of a negative sequence voltage measured during a fault, and wherein the second phase angle is the phase angle of a zero sequence voltage measured during the fault or a phase angle difference between the phase angle of a positive sequence voltage measured before the fault and the phase angle of a positive sequence voltage measured during the fault.

According to an embodiment, the plurality of phase angle deviations, the further plurality of phase angle deviations, the measured phase-angle deviation, or the further measured phase-angle deviation is or comprises a phase angle difference between a first phase angle and a second phase angle, wherein the first phase angle is a phase angle of a first sequence of a voltage or current measured before the fault at a point on the transmission line, wherein the second phase angle is a phase angle of a second sequence of the voltage or current measured during the fault at the point on the transmission line.

According to an embodiment, the transmission line carries a plurality of phases, and the processor is further configured to: obtain a plurality of voltage measurements of the first terminal measured before a fault and during the fault; determine a n-phase fault based on voltage differences between respective phases of the plurality of voltage measurements measured before the fault and the plurality of voltage measurements measured during the fault, wherein n is a natural number, larger than 1, corresponding to the number of the plurality of phases; and control the protection system is further based on the determined n-phase fault.

According to an embodiment, the processor is further configured to: obtain a plurality of current measurements of the first terminal; determine a generator type of the first generator based on the plurality of current measurements and/or the plurality of voltage measurements; and determine the measured phase-angle deviation based on the plurality of voltage measurements when the first generator is determined to be a first generator type; or determine the measured phase-angle deviation based on the plurality of current measurements when the first generator is determined to be a second generator type.

According to an embodiment, the first power source is one of a grid, a synchronous power source, an unconventional power source, in particular an inverter based resource, and wherein the second power source is a synchronous power or a grid with at least one synchronous power source and/or at least one unconventional power source.

According to an embodiment, the phase angle ranges of the at least three phase angle ranges do not overlap with one another.

According to an embodiment, the phase angle ranges of the at least three further phase angle ranges do not overlap with one another.

According to an embodiment, each of the at least three phase angle ranges includes the respective phase angle deviation of the plurality of phase angle deviations.

According to an embodiment, each of the at least three further phase angle ranges includes the respective phase angle deviation of the plurality of further phase angle deviations.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative methods, logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

**Claims**

1. A method for controlling a protection system for an electrical power system comprising a transmission line, the method comprising:

   determining a plurality of phase angle deviations based on network models of the electrical power system during respective faults of at least three faults;
   determining at least three phase angle ranges based on the plurality of phase angle deviations, wherein a sum of the at least three phase angle ranges is an angle of complete rotation; and
   controlling the protection system for the electrical power system based on the at least three phase angle ranges.

2. The method of claim 1, wherein the transmission line is terminated by a first terminal coupled to a first generator and by a second terminal coupled to a second generator, the method further comprising:

   obtaining a plurality of voltage measurements of the first terminal;
   determining a measured phase-angle deviation based on the plurality of voltage measurements;
   determining a fault by identifying in which of the at least three phase angle ranges the measured phase-angle deviation is located, in particular by comparing the measured phase-angle deviation to at least one of the at least three phase angle ranges; and
   controlling the protection system for the electrical power system based on the determined fault.

3. The method of claim 1 or 2, further comprising:

   determining a plurality of further phase angle deviations based on the network models of the electrical power system during the respective faults of at least three further faults; and
   determining at least three further phase angle ranges based on the further plurality of phase angle deviations, wherein a sum of the at least three further phase angle ranges is an angle of complete rotation.

4. The method of claim 3, further comprising:

obtaining a plurality of voltage measurements of the first terminal;

determining a further measured phase-angle deviation based on the plurality of voltage measurements;

determining the fault by identifying in which of the at least three further phase angle ranges the measured phase-angle deviation is located, in particular by comparing the measured phase-angle deviation to at least one of the at least three further phase angle ranges; and

controlling the protection system for the electrical power system based on the determined fault.

5. The method of any one of claims 1 to 4, further comprising:

obtaining a plurality of current measurements of the first terminal;

determining a zero-sequence current based on the plurality of current measurements of the first terminal;

determining the fault based further on the zero-sequence current, in particular by comparing a zero-sequence current to a preset value; and

controlling the protection system for the electrical power system based on the determined fault.

6. The method of any one of claims 1 to 5, wherein the measured phase-angle deviation is a phase angle difference between a first phase angle and a second phase angle, wherein the first phase angle is a phase angle of a negative sequence voltage measured during a fault, and wherein the second phase angle is a phase angle of a zero sequence voltage measured during the fault or a phase angle difference between a phase angle of a positive sequence voltage measured before the fault and a phase angle of a positive sequence voltage measured during the fault.

7. The method of any one of claims 4 to 6, wherein the plurality of phase angle deviations, the plurality of further phase angle deviations, the measured phase-angle deviation, or the further measured phase-angle deviation is or comprises a phase angle difference between a first phase angle and a second phase angle, wherein the first phase angle is a phase angle of a negative sequence voltage measured during a fault, and wherein the second phase angle is a phase angle of a zero sequence voltage measured during the fault or a phase angle difference between a phase angle of a positive sequence voltage measured before the fault and a phase angle of a positive sequence voltage measured during the fault.

8. The method of any one of claims 2 to 7, wherein the transmission line carries a plurality of phases, the method comprising:

obtaining a plurality of voltage measurements of the first terminal measured before a fault and during the fault;

determining a n-phase fault based on voltage differences between respective phases of the plurality of voltage measurements measured before the fault and the plurality of voltage measurements measured during the fault, wherein n is a natural number, larger than 1, corresponding to the number of the plurality of phases; and

controlling the protection system is further based on the determined n-phase fault.

9. The method of any one of claims 2 to 8, comprising:

obtaining a plurality of current measurements of the first terminal;

determining a generator type of the first generator based on the plurality of current measurements and/or the plurality of voltage measurements; and

determining the measured phase-angle deviation based on the plurality of voltage measurements when the first generator is determined to be a first generator type; or

determining the measured phase-angle deviation based on the plurality of current measurements when the first generator is determined to be a second generator type.

10. The method of any one of claims 2 to 6, wherein the first power source is one of a grid, a synchronous power source, an unconventional power source, in particular an inverter based resource, and wherein the second power source is a synchronous power or a grid with at least one synchronous power source and/or at least one unconventional power source.

11. The method of any one of claims 1 to 7, wherein the phase angle ranges of the at least three phase angle ranges do not overlap with one another.

12. The method of any one of claims 1 to 9,

wherein each of the at least three phase angle ranges includes the respective phase angle deviation the plurality of phase angle deviations .

13. A method for controlling a protection system for an electrical power system comprising a transmission line being terminated by a first terminal, the method comprising:

determining a plurality of phase angle deviations based on network models of the electrical power system during respective faults of at least three faults;
determining at least three phase angle ranges based on the plurality of phase angle deviations, wherein a sum of the at least three phase angle ranges is an angle of complete rotation;
obtaining a plurality of voltage and current measurements of the first terminal;
determining a measured phase-angle deviation based on the plurality of voltage measurements and a zero-sequence current based on the plurality of current measurements of the first terminal;
determining a fault based on the at least three phase angle ranges, the measured phase-angle deviation, and the zero-sequence current; and
controlling the protection system for the electrical power system based on the determined fault.

14. A device for controlling a protection system for an electrical power system comprising a transmission line, the device comprising a processor being configured to:

determine a plurality of phase angle deviations based on network models of the electrical power system during respective faults of at least three faults;
determine at least three phase angle ranges based on the plurality of phase angle deviations, wherein a sum of the at least three phase angle ranges is an angle of complete rotation; and
control the protection system for the electrical power system based on the at least three phase angle ranges.

15. A device for controlling a protection system for an electrical power system comprising a transmission line, the device comprising a processor being configured to:

determine a plurality of phase angle deviations based on network models of the electrical power system during respective faults of at least three faults;
determine at least three phase angle ranges based on the plurality of phase angle deviations, wherein a sum of the at least three phase angle ranges is an angle of complete rotation;
obtain a plurality of voltage and current measurements of the first terminal;
determine a measured phase-angle deviation based on the plurality of voltage measurements and a zero-sequence current based on the plurality of current measurements of the first terminal;
determine a fault based on the at least three phase angle ranges, the measured phase-angle deviation, and the zero-sequence current; and
control the protection system for the electrical power system based on the determined fault.

Determining a plurality of phase angle deviations based on network models of the electrical power system during respective faults of at least three faults

S101

Determining at least three phase angle ranges based on the plurality of phase angle deviations, wherein a sum of the at least three phase angle ranges is an angle of complete rotation

S102

Controlling the protection system for the electrical power system based on the at least three phase angle ranges

S103

FIG. 1

FIG. 2

FIG. 3

FIG. 4

a)

b)

FIG. 5

a)                                    b)

FIG. 6

a)

b)

c)

FIG. 7

S801 — determine $\delta_V^o$ & $\delta_V^+$

S802 — Compare $\delta_V^+$ to set 1 OR/AND set 2
Compare $\delta_V^o$ to set 3

Intermediate fault type

S803 — Is the intermediate fault type a single-phase-to-ground fault?

YES → Fault type = Phase-to-ground fault

NO → S804 — $I_0 > I_{th}$ ?

YES → Fault type = Phase-to-phase-to-ground fault

NO → Fault type = Phase-to-phase fault

FIG. 8

S901 — **Determine** $I_o$

S902 — $I_O > I_{th}$ ?

**YES**

**NO**

**Determine** $\delta_V^o$ & $\delta_V^+$

**Determine** $\delta_V^+$

**Compare** $\delta_V^+$ **to set 1 OR/AND set 2**
**Compare** $\delta_V^o$ **to set 3**

**Compare** $\delta^+$ **to set 4**

**Fault type =**
**Phase-to-ground fault or**
**Phase-to-phase-to-ground fault**

**Fault type =**
**Phase-to-phase fault**

FIG. 9

FIG. 10

EP 4 346 040 A1

a)

b)

FIG. 11

a)

b)

FIG. 12

a)

b)

c)

FIG. 13

EP 4 346 040 A1

a)

b)

FIG. 14

a)

b)

FIG. 15

FIG. 16

a)

b)

FIG. 17

a)

b)

FIG. 18

FIG. 19

a)

b)

c)

FIG. 20

EP 4 346 040 A1

FIG. 21

EP 4 346 040 A1

| | Wind type IV (From Bus M) | | | Wind type IV (From Bus N) | | |
|---|---|---|---|---|---|---|
| | Number of test case passed | Percentage of test case passed (%) | Average time (ms) | Number of test case passed | Percentage of test case passed (%) | Average time (ms) |
| First approach | 582 | 88.18 | 26.65 | 504 | 76.36 | 30.22 |
| Second approach | 568 | 86.06 | 32.38 | 504 | 76.36 | 30.22 |
| Method of the present disclosure | 660 | 100 | 11.15 | 652 | 98.78 | 12.19 |

FIG. 22

FIG. 23

EP 4 346 040 A1

| | Wind type III (From Bus M) | | | Wind type III (From Bus N) | | |
|---|---|---|---|---|---|---|
| | Number of test case passed | Percentage of test case passed (%) | Average time (msec) | Number of test case passed | Percentage of test case passed (%) | Average time (msec) |
| First approach | 471 | 89.20 | 22.89 | 408 | 77.27 | 27.31 |
| Second approach | 452 | 85.61 | 28.78 | 393 | 74.43 | 35.67 |
| Method of the present disclosure | 528 | 100 | 9.30 | 528 | 100 | 10.11 |

FIG. 24

FIG. 25

EP 4 346 040 A1

| | Solar PV (From Bus M) | | | Solar PV (From Bus N) | | |
|---|---|---|---|---|---|---|
| | Number of test case passed | Percentage of test case passed (%) | Average time (msec) | Number of test case passed | Percentage of test case passed (%) | Average time (msec) |
| First approach | 453 | 85.80 | 26.05 | 408 | 77.27 | 27.91 |
| Second approach | 412 | 78.03 | 32.52 | 392 | 74.24 | 35.44 |
| Method of the present disclosure | 528 | 100 | 9.62 | 524 | 99.24 | 10.45 |

FIG. 26

FIG. 27

EP 4 346 040 A1

| | Wind type IV (From Bus M) | | | Wind type IV (From Bus N) | | |
|---|---|---|---|---|---|---|
| | Number of test case passed | Percentage of test case passed (%) | Average time (msec) | Number of test case passed | Percentage of test case passed (%) | Average time (msec) |
| First approach | 443 | 83.90 | 24.09 | 394 | 74.62 | 28.56 |
| Second approach | 441 | 83.52 | 30.97 | 378 | 71.59 | 36.94 |
| Method of the present disclosure | 528 | 100 | 9.55 | 523 | 99.05 | 10.63 |

FIG. 28

|  | Wind type IV (From R3) | | | Wind type IV (From R1) | | | Wind type IV (From R2) | | |
|---|---|---|---|---|---|---|---|---|---|
|  | Number of test case passed | Percentage of test case passed (%) | Average time (msec) | Number of test case passed | Percentage of test case passed (%) | Average time (msec) | Number of test case passed | Percentage of test case passed (%) | Average time (msec) |
| First approach | 201 | 83.75 | 29.57 | 192 | 80.00 | 29.53 | 229 | 95.42 | 24.56 |
| Second approach | 195 | 81.25 | 34.68 | 169 | 70.42 | 37.75 | 174 | 72.50 | 43.09 |
| Method of the present disclosure | 240 | 100.00 | 11.64 | 240 | 100.00 | 12.17 | 238 | 99.17 | 11.78 |

FIG. 29

3010

Device

a)

3020

Computer-readable
medium

b)

3000

3010

Device

3020

Computer-readable
medium

3030

Transmission line

c)

FIG. 30

Europäisches
Patentamt

European
Patent Office

Office européen
des brevets

# EUROPEAN SEARCH REPORT

**Application Number**

EP 22 20 7618

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HOOSHYAR ALI ET AL: "Fault Type Classification in Microgrids Including Photovoltaic DGs", IEEE TRANSACTIONS ON SMART GRID, IEEE, USA, vol. 7, no. 5, 1 September 2016 (2016-09-01), pages 2218-2229, XP011620657, ISSN: 1949-3053, DOI: 10.1109/TSG.2015.2451675 [retrieved on 2016-08-19] Sections I,; * abstract * * Sections I,II,IV * ----- | 1-4,6-8, 10-12,14 | INV. H02H3/00 G01R31/08 G01R31/52 H02H3/34 H02H7/26 |
| | | | TECHNICAL FIELDS SEARCHED (IPC) |
| | | | H02H G01R |

The present search report has been drawn up for all claims

| Place of search | Date of completion of the search | Examiner |
|---|---|---|
| Munich | 17 August 2023 | Palukova, Mila |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

Europäisches
Patentamt

European
Patent Office

Office européen
des brevets

**Application Number**

**EP 22 20 7618**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

**see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

**1-4, 8, 10-12, 14(completely); 6, 7(partially)**

☐ The present supplementary European search report has been drawn up for those parts of the European patent application which relate to the invention first mentioned in the claims (Rule 164 (1) EPC).

66

Europäisches
Patentamt

European
Patent Office

Office européen
des brevets

**LACK OF UNITY OF INVENTION**

**SHEET B**

Application Number

EP 22 20 7618

The Search Division considers that the present European patent application does not comply with the
requirements of unity of invention and relates to several inventions or groups of inventions, namely:

1. claims: 1-4, 8, 10-12, 14(completely); 6, 7(partially)

   A method according to claim 1, wherein the method further
   comprises:
   determining a plurality of further phase angle deviations
   based on the network models of the electrical power system
   during the respective faults of at least three further
   faults; and
   determining at least three further phase angle ranges based
   on the further plurality of phase angle deviations, wherein
   a sum of the at least three further phase angle ranges is an
   angle of complete rotation.

   ---

2. claims: 5, 13, 15

   A method according to claim 1, the method further
   comprising:
   obtaining a plurality of current measurements of the first
   terminal;
   determining a zero-sequence current based on the plurality
   of current measurements of the first terminal;
   determining the fault based further on the zero-sequence
   current, in particular by comparing a zero-sequence current
   to a preset value; and
   controlling the protection system for the electrical power
   system based on the determined fault.

   ---

3. claims: 6, 7(partially)

   A method according to claim 1, wherein
   the measured phase-angle deviation is a phase angle
   difference between a phase angle of a positive sequence
   voltage measured before the fault and a phase angle of a
   positive sequence voltage measured during the fault.

   ---

4. claim: 9

   A method according to claim 1, wherein the transmission line
   is terminated by a first terminal coupled to a first
   generator and by a second terminal coupled to a second
   generator, the method further comprising obtaining a
   plurality of voltage measurements of the first terminal;
   determining a measured phase-angle deviation based on the
   plurality of voltage measurements;
   determining a fault by identifying in which of the at least
   three phase angle ranges the measured phase-angle deviation
   is located, in particular by comparing the measured
   phase-angle deviation to at least one of the at least three

page 1 of 2

Europäisches
Patentamt

European
Patent Office

Office européen
des brevets

**LACK OF UNITY OF INVENTION
SHEET B**

**Application Number**

EP 22 20 7618

The Search Division considers that the present European patent application does not comply with the requirements of unity of invention and relates to several inventions or groups of inventions, namely:

```
phase angle ranges; and controlling the protection system
for the electrical power system based on the determined
fault and wherein the method further comprises:
obtaining a plurality of current measurements of the first
terminal;
determining a generator type of the first generator based on
the plurality of current measurements and/or the plurality
of voltage measurements; and
determining the measured phase-angle deviation based on the
plurality of voltage measurements when the first generator
is determined to be a first generator type; or
determining the measured phase-angle deviation based on the
plurality of current measurements when the first generator
is determined to be a second generator type.
                         ---
```

**page 2 of 2**